(19) Europäisches Patentamt
European Patent Office
Office européen des brevets

(11) **EP 0 616 726 B1**

(12) **EUROPEAN PATENT SPECIFICATION**

(45) Date of publication and mention
of the grant of the patent:
**06.06.2001 Bulletin 2001/23**

(51) Int Cl.[7]: **H01L 27/115**, H01L 21/3205, H01L 29/92

(21) Application number: **93901364.5**

(22) Date of filing: **08.12.1992**

(86) International application number:
**PCT/US92/10627**

(87) International publication number:
**WO 93/12542 (24.06.1993 Gazette 1993/15)**

(54) **LAYERED SUPERLATTICE MATERIAL APPLICATIONS**

VERWENDUNG VON SCHICHTIGEM ÜBERGITTER MATERIAL

MATERIAUX PRESENTANT UNE SURSTRUCTURE STRATIFIEE

(84) Designated Contracting States:
**AT CH DE FR GB IE IT LI NL**

(30) Priority: **13.12.1991 US 807439**
**23.10.1992 US 965190**

(43) Date of publication of application:
**28.09.1994 Bulletin 1994/39**

(73) Proprietor: **SYMETRIX CORPORATION**
**Colorado Springs, CO 80918 (US)**

(72) Inventors:
• **PAZ DE ARAUJO, Carlos, A.**
**Colorado Springs, CO 80919 (US)**
• **CUCHIARO, Joseph, D.**
**Colorado Springs, CO 80918 (US)**
• **SCOTT, Michael, C.**
**Colorado Springs, CO 80918 (US)**
• **McMILLAN, Larry, D.**
**Colorado Springs, CO 80909 (US)**

(74) Representative: **Goodanew, Martin Eric et al**
**MATHISEN, MACARA & CO.**
**The Coach House**
**6-8 Swakeleys Road**
**Ickenham Uxbridge UB10 8BZ (GB)**

(56) References cited:
EP-A- 0 338 157      EP-A- 0 415 751
EP-A- 0 448 151      EP-A- 0 489 519
US-A- 5 146 299

• **JOURNAL OF APPLIED PHYSICS vol. 46, no. 7, July 1975, NEW YORK US pages 2877 - 2881 K.SUGIBUCHI ET AL. 'FERROELECTRIC FIELD-EFFECT MEMORY DEVICE USING Bi4Ti3012'**
• **PATENT ABSTRACTS OF JAPAN vol. 014, no. 546 (E-1008)4 December 1990**
• **Takashi Mihara, Hitoshi Watanabe, C A Paz de Araujo, J Cuchiaro, M Scott, L D McMillan: "Feasability for Memory Devices and Electrical Characterization of Newly Developed Fatigue Free Capacito**
• **American Heritage Dictionary of the English Language, New College Ed. Houghton Mifflin Co. Boston, 1980, p. 1248**
• **SMOLENSKII ET AL: "Ferroelectrics fo the Oxygen-Octahedral Type with Layered Structure", SOVIET PHYSICS -SOLID STATE, , 30-09-1961, vol. 3, no. 3, pages 651 to 655**
• **SMOLENSKII et al: "Dielectric Polarization of Number of Complex Compounds", Fizika Tverdogo Tela, V. 1, No. 10, pp.1562-1572, October 1959**
• **M. J. Cooke, "Semiconductor Devices" Prentice Hall, New York (1990) pp. 194-195**
• **"Electronics Engineers' Handbook", ed. by D Fink and D Christiansen, 3rd ed., McGraw Hill Book Co., New York (1989), p. 6-89**
• **"VLSI Technology", ed. by S M Sze, 2nd ed. McGraw Hill Book Co. New York (1988), p. 416**
• **H Buhay, S Sinharoy, M H Francombe, D R Lampe, W H Kasner et al: "Pulsed Laser Deposition (PLD) of Oriented Bismuth Titanate Films for Integrated Electronic Applications", Intnl. Symposium on**

- P C Joshi et al: "Structural and Optical Properties of Ferroelectric Thin Films by Sol-gel Technique," Appl. Phys. Lett., Vol 59, No 10, Nov 1991
- Smolenskii et al: "Ferroelectrics and Related Materials," Gordan and Breach Science Pulishers, New York, ISSN 0275-9608, pp 698-703
- Encylopedia of Semiconductor Technology, ed. by M Grayson, John Wiley and Sons, 1984, "Ferroelectrics" pp. 248-249 and Figure 10
- Wu: "A New Ferroelectric Memory Device, Metal-Ferroelectric-Semiconductor Transistor," IEEE Trans. Electron Devices, Vol ED-21, No 8, August 1974, pp 499-504
- Wu: "Memory Retention and Switching Behaviour of Metal-Ferroelectric-Semiconductor Transistors," Ferroelectrics, Gordan and Breach Science Publishers Ltd, 1976, Vol 11, pp 379-383
- I P Batra, P Wurfel and B D Silverman: "Phase Transistion , Stability, and Depolarization Field in Ferroelectric Thin Films," Physical Review B, Vol 8, No 7, 01-10-1973, pp 3257-3265
- R Vest and Jiejie Xu: "PbTiO3 Films From Metalloorganic Precursors," IEEE Trans. on Ultrasonics. Ferroelectrics and Frequency Control, Vol 35, No 6, Nov. 1988, pp 711-717
- "Principles and Applications of Ferroelectrics and Related Materials," M E lines and A M Glass, Appendix F, pp 620-633

Remarks:

The file contains technical information submitted after the application was filed and not included in this specification

## Description

1. Field of the Invention

The invention in general relates to the structure and fabrication of electrical devices such as integrated circuits and more particularly to a new class of materials that provide low fatigue ferroelectric devices, reliable high dielectric constant devices, and are resistant generally to degradation in electronic applications.

2. Statement of the Problem

It has been known for many years that ferroelectric materials have polarization states that can be selected or switched by application of an electric field, and that these polarization states remain after the electric field is removed. It is well-known that if a ferroelectric capacitor is substituted for the conventional silicon dioxide dielectric capacitor in a conventional memory, such as a DRAM, instead of simply storing a charge that leaks off quickly, the capacitor can be switched between selected polarization states that will remain indefinitely after power is removed. Further, it is well-known that ferroelectric materials are much more resistant to radiation damage than conventional memory materials, and do not need high voltage for writing or erasing as conventional non-volatile memories. Thus, considerable research and development has been directed toward ferroelectrics over the last thirty years. However, only a few specialty ferroelectric integrated circuits have been commercially produced. United States Patent No. 5,028,455 issued to William D. Miller et al. and the article "Process Optimization and Characterization of Device Worthy Sol-Gel Based PZT for Ferroelectric Memories", in Ferroelectrics, Vol 109, pp. 1-23 (1990) summarize the various ferroelectric materials utilized in non-volatile memories. These materials include potassium nitrate ($KNO_3$), PLZT ($PbLa_2O_3$ - $ZrO_2$ - $TiO_2$), lead zirconate titanate or PZT ($PbTiO_3$ - $PbZrO_3$), and lead titanate ($PbTiO_3$), with PZT currently being the material of choice. These ferroelectric materials are all random solid solutions meeting the general perovskite formula $ABO_3$.

A key problem in producing a non-volatile ferroelectric memory has been that up to now every ferroelectric material that has had acceptably high polarizability to be useful for a non-volatile memory has also been characterized by a high fatigue rate. That is, under repeated switching, the polarizability gradually decreases to less than 50% of the original polarizability. Moreover, when a series of pulses of the same sign are applied to the prior art materials, they take a set, or an imprint. As a result, when a field is applied to switch the material, it takes a longer time for the material to respond. Moreover, when the material is switched it may relax back into the opposite state. At worst this causes the material to unusable as a memory. At best, the timing of the memory must be slowed down considerably to account for the longest switching time. A further problem with prior art ferroelectric materials is that the effective polarizability changes dramatically with the thickness of the material, generally decreasing as the material becomes thinner. This problem makes it difficult or impossible to make practical integrated circuits with the prior art materials, because integrated circuits are fabricated using thin films. Another problem has been that the ferroelectric materials tend to be incompatible with the semiconductor materials and structures used in integrated circuits. When the ferroelectric materials are combined with the conventional materials in conventional integrated circuit structures, they tend to interdiffuse with the other materials which either damages the ferroelectrics and other materials, alters their properties, or both. The ferroelectric materials also tend to lose their ferroelectric properties at the relatively sharp bends utilized in conventional memory device fabrication. Thus there remains a need for a ferroelectric integrated circuit structure and fabrication method that results in reliable, low cost, high density integrated circuit devices.

There has also been a need for a high dielectric constant material suitable for use in integrated circuits. The most commonly used dielectric material in integrated circuits is silicon dioxide, which has a dielectric constant of about 4. Capacitors using such a material must have a large area in order to provide the capacitive values required in state-of-the-art integrated circuits. These large areas make it difficult to reach high densities of capacitive components in an integrated circuit. However, the use of other materials to provide the dielectric in integrated circuits has been hindered by many of the same problems as ferroelectric memories: leakage of the dielectrics in the integrated circuit environment, degradation and breakdown of the materials caused by the stresses of fabrication and use over long time periods, and incompatibility of the materials with other common integrated circuit materials. As integrated circuits become smaller, this lack of a suitable high dielectric constant material becomes more and more significant. It is considered to be one of the serious roadblocks to 64 megabit and higher integrated circuit memories.

Up to now, the sciences of ferroelectrics and integrated circuit dielectric materials has been phenomenological. Researchers have made and tested a large number of materials and those which are found to be ferroelectric or to have high dielectric constants have been included in lengthy lists. See for example, Appendix F of Principles and Applications of Ferroelectrics and Related Materials, by M.E. Lines and A. M. Glass, Clarendon Press, Oxford, 1977, pp. 620 - 632. Generally the ferroelectrics in these lists have been separated into several classes such as the complex salts, such as $KD_2PO_4$, the TGS type, such as tri-glycine sulfate, the perovskites, such as $BaTiO_3$, $SrTiO_3$ and PZT, or the tungsten bronzes, etc. The various classes a particular author chooses depends on his or her point of view. One class of ferroelectrics discovered by G.A. Smolenskii, V.A. Isupov, and A.I. Agranovskaya had a layered perovskite structure. See Chapter 15 of the book, <u>Ferroelectrics and Related Materials</u>, ISSN 0275-9608, (V.3 of the series Ferroelectrics and Related Phenomena, 1984) edited by G. A. Smolenskii, especially sections 15.3 -15.7; and pages 624 & 625 of Appendix F of the Lines and Glass reference cited above.

Up to now, these layered ferroelectric materials have not been considered as being suitable for non-volatile ferroelectric memories, nor have they been recognized as useful high dielectric constant materials. Two of the layered ferroelectric materials, bismuth titanate ($Bi_4Ti_3O_{12}$) and barium magnesium fluoride ($BaMgF_4$), have been tried in a switching memory application as a gate on a transistor. See "A New Ferroelectric Memory Device, Metal-Ferroelectric-Semiconductor Transistor", by Shu-Yau Wu, <u>IEEE Transactions On Electron Devices, August 1974</u>, pp. 499- 504, which relates to the $Bi_4Ti_3O_{12}$ device, and the article "Integrated Ferroelectrics" by J.F. Scott, C.A. Paz De Araujo, and L.D. McMillian in <u>Condensed Matter News</u>, Vol. 1, No. 3, 1992, pp. 16 - 20, which article is not prior art to this disclosure, but Section IIB discusses experiments with ferroelectric field effect transistors (FEFETs). However, neither of these devices have been successfully used in a memory. In the case of the $Bi_4Ti_3O_{12}$ device, the ON state decayed logarithmically after only two hours, and in the case of the $BaMgF_4$ device, both states decayed exponentially after a few minutes. See "Memory Retention And Switching Behavior Of Metal-Ferroelectric-Semiconductor Transistors", by S. Y. Wu, <u>Ferroelectrics</u>, 1976 Vol. 11, pp. 379 -383. Further, the $Bi_4Ti_3O_{12}$ device was not annealed, and it is well known that at annealing temperatures, the titanium in $Bi_4Ti_3O_{12}$ will react with the silicon in the substrate to form titanium silicide, a conductor, which will degrade the device beyond usefulness. Since without annealing $Bi_4Ti_3O_{12}$ is not stable, and further since many of the materials in conventional integrated circuits require annealing for stability, thus any material used in such circuits must be able to withstand the annealing temperatures, the prior art suggests that useful memories cannot be made with $Bi_4Ti_3O_{12}$. In the case of the $BaMgF_4$ devices, the "polarized" state dissipates so rapidly that it is believed that the $BaMgF_4$ is acting as an electret rather than a ferroelectric; that is, it is taking on a charged state and the state decays because the charge leaks off. Thus the prior art suggests that these materials cannot be used in a practical integrated circuit.

Another type of multilayered material structure, called a multilayered hetero-superlattice structure, is disclosed in Patent Abstracts of Japan, vol. 14, no. 546, 4.12.90, which is an abstract Japanese Laid Open-Patent Application No. 2-232974. The multiple layers of these hetero-superlattice structures are individually formed by a mechanism external to the material itself, e.g. by individually growing a layer of $MgAl_2O_4$ a few atoms thick using chemical vapor deposition process (CVD), then growing a layer of PZT a few atoms thick using a pressurized CVD, then growing another layer of $MgAl_2O_4$ a few atoms thick, etc. Japanese 2-232974 patent application referenced above discloses that the hetero-superlattice structure provides improved electronic properties, but not so improved as to make a viable commercial non-volatile memory feasible. Moreover, the hetero-superlattice structure is laborious and painstaking to fabricate.

A ferroelectric field-effect transistor having a thin film of bismuth titanate on a silicon substrate is known from the article "Ferroelectric field-effect memory device using $Bi_4 Ti_3 O_{12}$ film", K. Sugibuchi, Y. Kurogi and N. Endo, J. Appl. Phys. Vol. 46, No. 7, July 1975, pp. 2877-2881. Moreover, a capacitor having a thin film of bismuth titanate is known from EP-A-0 415 751.

*3. Solution to the Problem*

The invention solves the above problems by recognizing that a class of materials, called layered superlattice materials herein, are useful in integrated circuits. In particular the materials are highly useful as ferroelectric switching materials and as high dielectric constant materials.

More specifically, the invention provides an integrated circuit memory as defined in claim 1.

The inventors have discovered that intermediate layers between the ferroelectric layers in a ferroelectric layered superlattice material provide a "shock absorber" effect. This shock absorber effect prevents degradation of the ferroelectric material by repetitive switching. As a result the materials essentially do not fatigue and do not take an imprint. Further, the layered structure separates the dipoles that create the ferroelectric properties into very small domains, each of which has only a tiny space charge associated with it. As a result the surface effects do not occur, and the polarizability of these materials hardly varies with film thickness.

The shock absorber effect also prevents degradation or leaking of high dielectric constant materials.

Moreover, it has been discovered that the layered superlattice structure supports and binds the materials into desirable compounds that would not otherwise be stable without the superlattice.

As a result of the above features, the layered superlattice material lends itself to the creation of stable new materials and integrated circuit structures.

Many of these materials are compatible with conventional integrated circuit materials. For those that are not compatible, such as $Bi_4Ti_3O_{12}$, the invention provides buffer layers which prevent diffusion and other material-degrading and electrical property degrading reactions from occurring.

While the layered superlattice materials have not up to now been recognized as being useful in integrated circuits, we have discovered that they are much more useful than any prior ferroelectric and high dielectric constant materials. Moreover, the shock absorber effect of the layered structure prevents the degradation of these properties by integrated circuit fabrication processes and structures, and the repetitive use common for integrated circuits. Thus reliable, durable materials having many desirable properties for integrated circuits and other electrical uses can be fabricated.

The problem of fatigue in ferroelectric switching devices is solved by utilizing a layered superlattice material as the ferroelectric switching material. The problem of fatigue in ferroelectric memories is solved by using a layered superlattice material in the storage cell of the memory. For example, strontium bismuth tantalate ($SrBi_2Ta_2O_9$) has been made in thin films suitable for use in integrated circuits and having a polarizability, 2Pr, of 25 microcoulombs/cm$^2$ and showing less than 5% fatigue after $10^{10}$ cycles, which is equivalent to 10 years use in a typical integrated circuit switching device.

The problem of the need for a high dielectric constant material has been solved by utilizing a layered super-lattice material as the dielectric in an integrated circuit. As an example, barium bismuth tantalate ($BaBi_2Ta_2O_9$) having a dielectric constant of 166, measured at 1 Megahertz with a $V_{osc}$ of 15 millivolts, and a leakage current of 7.84 X 10$^{-8}$ amps/cm$^2$ at a field of 200 KV/cm has been made in thin films of less than 2000 Å (1Å = 0.1 nm), which are suitable for use in integrated circuits.

The solution of the above problems leads to other applications for the materials. Now that the function of the layered superlattice structure in providing a shock absorber effect which leads to lower fatigue and greater durability in ferroelectric and dielectric applications is understood, the principal can be applied to many other applications.

## BRIEF DESCRIPTION OF THE DRAWINGS

Fig. 1A is a top view of a silicon wafer on which thin film capacitors according to the invention are shown greatly enlarged;

Fig. 1B is a portion of the cross-section of Fig. 1A taken through the lines 1B - 1B, illustrating a thin film capacitor device having buffer layers according to the invention;

Fig. 2 is a cross-sectional illustration of a portion of a thin film capacitor according to the invention;

Fig. 3A is a circuit diagram of an integrated circuit memory which is a preferred use of the material according to the invention;

Fig. 3B is a circuit diagram of an individual integrated circuit non-volatile memory cell such as may be used in the memory of Fig. 3A and utilizing the low fatigue ferroelectric switching material according to the invention;

Fig. 3C is a circuit diagram of an individual integrated circuit volatile memory cell such as which may be used in the memory of Fig. 3A and utilizing the high dielectric material according to the invention;

Fig. 3D is an illustration of how the cells of Figs. 3B and 3C may be implemented in an integrated circuit memory;

Fig. 4 shows a graph of $P_r^-$ and $P_r^+$ versus number of hysteresis cycles for a hysteresis curve of a device as shown in Fig. 1B having a layer of $Bi_4Ti_3O_{12}$ between buffer layers of $SrTiO_3$, illustrating the low fatigue of the material;

Fig. 5A is an initial hysteresis curve of a device as shown in Fig. 1B having a layer of $SrBi_4Ti_4O_{15}$ between buffer layers of $SrTiO_3$;

Fig. 5B is the hysteresis curve for the same sample as used to generate the curve of Fig. 5A, except after $10^{10}$ cycles;

Fig. 6A is 2Prp and 2Prn versus number of switching cycles for a ferroelectric capacitor as shown in Fig. 2 utilizing $SrBi_2Ta_2O_9$ as the ferroelectric material;

Fig. 6B shows hysteresis curves at 2, 4, 6, 8, and 10 volts for a further ferroelectric capacitor as shown in Fig. 2 also utilizing $SrBi_2Ta_2O_9$ as the ferroelectric material;

Fig. 7 is a graph of 2Prp and 2Prn versus number of switching cycles for a ferroelectric capacitor as shown in Fig. 2 utilizing $SrBi_2Nb_2O_9$ as the ferroelectric material;

Figs. 8A and 8B are PUND switching measurements taken of a ferroelectric capacitor as shown in Fig. 2C utilizing $SrBi_2TaNbO_9$ as the ferroelectric material with pulses of 5 volts and 10 volts respectively;

Fig. 8C shows hysteresis measurements performed on the sample of Figs. 8A and 8B at twenty different data points over approximately $10^{10}$ hysteresis cycles;

Fig. 8D is a graph of 2Pr versus number of cycles taken from the hysteresis curves of Fig. 8C;

Fig. 8E is a graph of 2Prp and 2Prn versus number of switching cycles for the sample of Figs. 8A through 8D;

Fig. 9 is a graph of the logarithm of the DC leakage current versus applied field for a capacitor as shown in Fig. 2C utilizing $BaBi_2Ta_2O_9$ as the high dielectric constant material;

Fig. 10 is a graph of the logarithm of the DC leakage current versus applied field for a capacitor as shown in Fig.

2C utilizing $PbBi_2Ta_2O_9$ as the high dielectric constant material;

Fig. 11 is a graph of the logarithm of the DC leakage current versus applied field for a capacitor as shown in Fig. 2C utilizing $BaBi_2Nb_2O_9$ as the high dielectric constant material;

Fig. 12A illustrates the perovskite primitive unit cell;

Fig. 12B illustrates another perovskite unit cell which is more useful for describing the invention;

Fig. 13 illustrates a layered superlattice material according to the invention;

Fig. 14 shows the specific lattice structure for an $ABi_2B_2^{+5}O_9$ layered superlattice material;

Fig. 15 shows the specific lattice structure for an $ABi_2B_4^{+4}O_9$ layered superlattice material;

Fig. 16 shows a hysteresis curve for a sample of $SrBi_2Ta_2O_9$ after $10^{12}$ cycles superimposed on an initial hysteresis curve for the same sample;

Fig. 17 shows 2PR versus number of hysteresis cycles for three samples of $SrBi_2Ta_2O_9$, with the test for one sample going out to $10^{12}$ cycles;

Fig. 18 shows superimposed PUND switching measurements performed on a sample of $SrBi_2Ta_2O_9$ at 17 data points over approximately $10^{10}$ switching cycles at a temperature of $100°C$;

Fig. 19 shows the switching charge versus number of switching cycles for the PUND measurements of Fig. 18;

Fig. 20 shows PUND measurements for a sample of $SrBi_2Ta_2O_9$ taken after the sample had retained a polarization charge for 80 days at $100°C$ superimposed on the initial PUND measurements for the same sample;

Fig. 21 shows the decay of a switching charge for a positive and negative polarization state for a sample of $SrBi_2Ta_2O_9$ illustrating data retention over an eighty day period at $100°C$;

Fig. 22A shows the results of an initial PUND measurement for a sample of $SrBi_2Ta_2O_9$;

Fig. 22B shows the results of a PUND measurement taken on a sample of $SrBi_2Ta_2O_9$ after pulsing the sample with bipolar pulses at 1 MHZ for one hour at $84°C$;

Fig. 22C shows the results of a PUND measurement taken on a sample of $SrBi_2Ta_2O_9$ after pulsing the sample with positive pulses at 1 MHZ for one hour at $84°C$;

Fig. 22D shows the results of a PUND measurement taken on a sample of $SrBi_2Ta_2O_9$ after pulsing the sample with negative pulses at 1 MHZ for one hour at $84°C$; and

Fig. 23 shows 2PR versus electric field for four different samples of $SrBi_2Ta_2O_9$ having a variety of thicknesses;

## DESCRIPTION OF THE PREFERRED EMBODIMENT

The inventors have discovered that a class of materials that have never before been successfully utilized in non-volatile ferroelectric switching memories, in ferroelectric switching capacitors, or as high dielectric constant materials in volatile memories, are considerably superior to all previous materials used in such applications. In particular these materials exhibit low fatigue in switching applications, little or no imprinting, little change in the polarizability with film thickness, long retention of polarization charge even under high stress conditions, a high dielectric constant with low leakage current, and are compatible with, or can be designed to be compatible with, the other materials commonly used in integrated circuits, such as silicon and gallium arsenide. The invention can perhaps best be understood by a description of how the excellent ferroelectric switching and high dielectric constant properties of these materials were discovered.

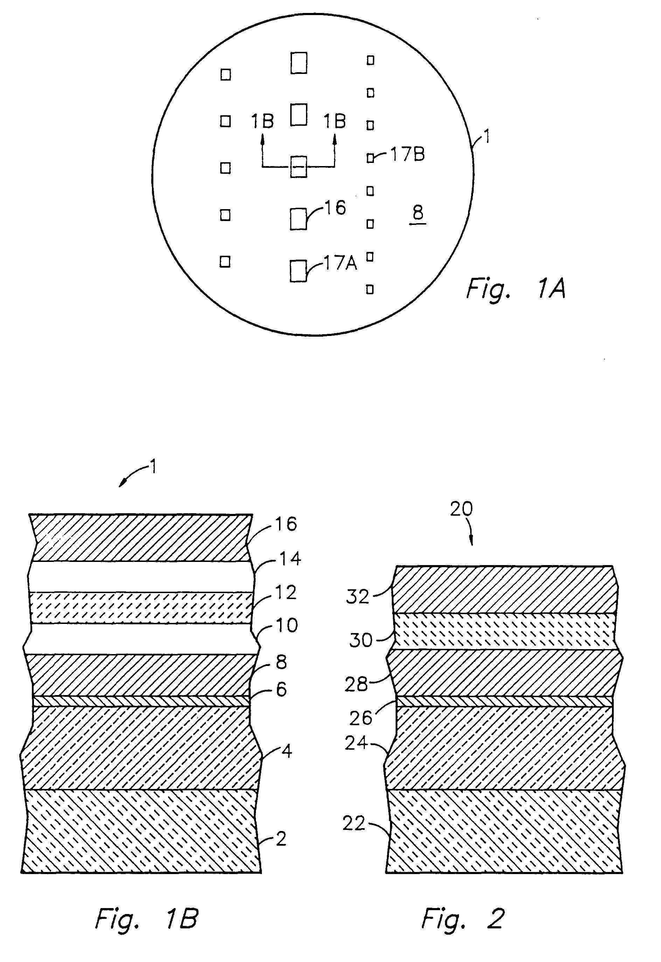

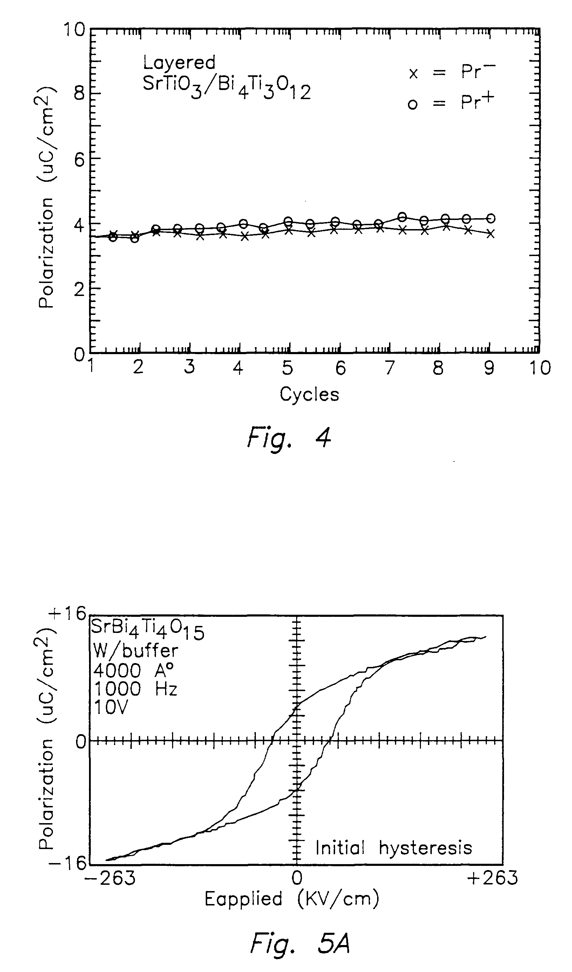

As indicated above, it was realized that one of the problems with previous ferroelectric switching capacitors made of materials such as PZT was that a large space charge accumulated at the interfaces of the ferroelectric material and the capacitor electrodes. This space charge screened the interior of the ferroelectric material from the applied field, and thus most of the ferroelectric switching was taking place at the surface of the material. It was postulated that the poor fatigue properties of the prior ferroelectric materials may have been related to this space charge phenomenon. Thus a layered ferroelectric capacitor structure as shown in Fig. 1B was fabricated having a substrate 2 of silicon, a silicon oxide insulating layer 4, a platinum first capacitor electrode 8, platinum second capacitor electrode 16, a thin layer of titanium 6, and a ferroelectric material 12, such as $Bi_4Ti_3O_{12}$, sandwiched between layers 10, 14 of a high dielectric constant material, such as $SrTiO_3$. It was thought that the layered structure of the pure ferroelectric material 12 sandwiched between layers 10, 14 of a high dielectric constant material might make the space charge gradient into the ferroelectric material more gradual. The material of the layers 10 and 14 was also selected to buffer the $Bi_4Ti_3O_{12}$ from the other capacitor layers to prevent diffusion and undesirable reactions. When hysteresis endurance tests were performed on this layered structure, a graph of switching charge versus cycles as illustrated in Fig. 4 showing almost no fatigue out to beyond $10^9$ cycles, which is equivalent to ten years use in a memory, was generated. At first this was thought to illustrate the success of the layered structure, but capacitance measurements suggested that the ferroelectric switching was occurring in a layer of material much thinner than the layer of $Bi_4Ti_3O_{12}$. It was conjectured that what had happened was that the $SrTiO_3$ and the $Bi_4Ti_3O_{12}$ had interdiffused at their interfaces and that the low fatigue results were that of a material such as $SrBi_4Ti_4O_{15}$ which had hitherto not been suspected of being a likely candidate for a non-volatile memory or other ferroelectric switching application. A structure as shown in Fig. 1B with a layer of 12 of

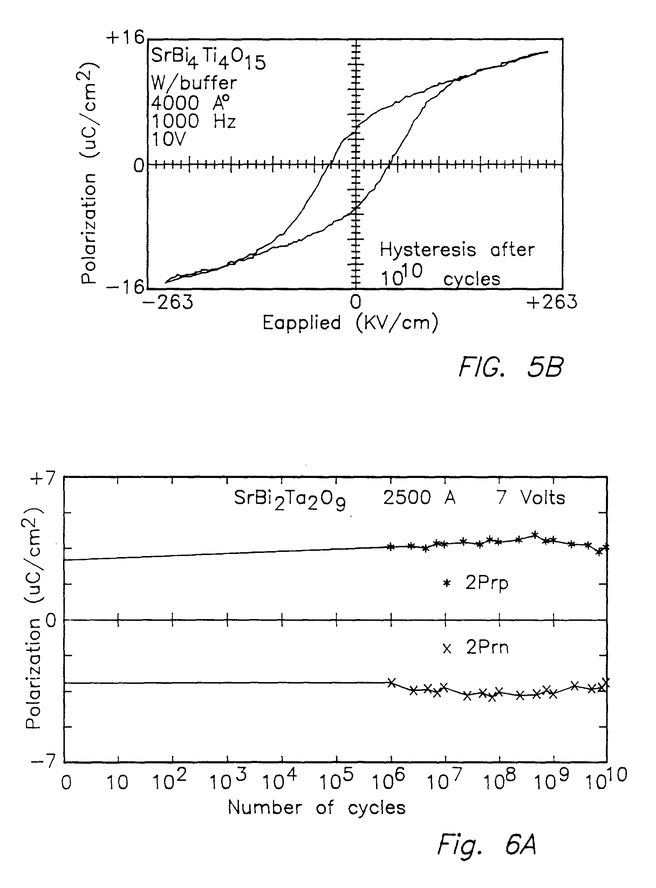

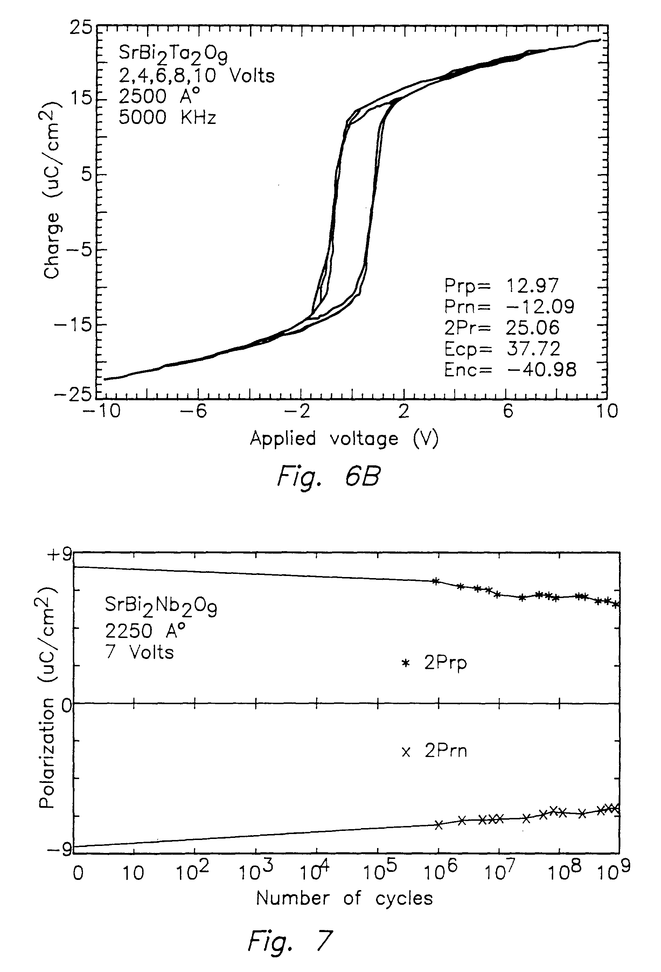

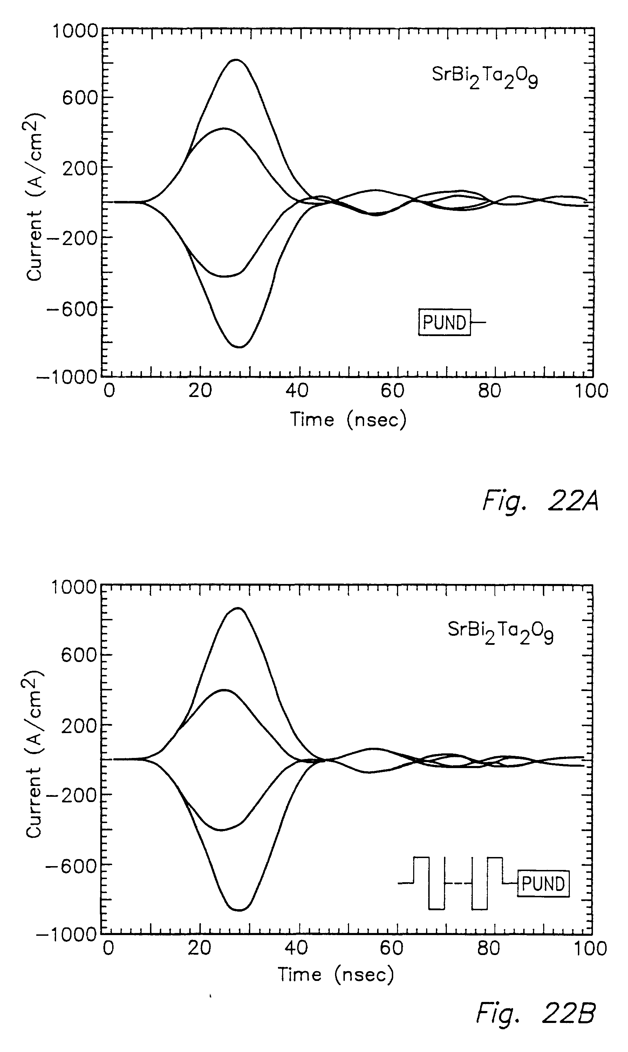

$SrBi_4Ti_4O_{15}$ sandwiched between two layers 10, 14 of $SrTiO_3$ was fabricated. Tests were performed yielding an initial hysteresis curve as shown in Fig. 5A and a hysteresis curve after $10^{10}$ cycles as shown in Fig. 5B. A comparison of these curves indicates fatigue of well below 30%, which is much less than for any ferroelectric material on which endurance tests had been performed in the prior art. It was realized that the $SrBi_4Ti_4O_{15}$ was one of the layered perovskite-like materials catalogued by Smolenskii, and thought that perhaps the natural layered structure of these materials might be the source of the low-fatigue property. Other devices were fabricated having the structure shown in Fig. 2, i.e. a silicon substrate 22, a silicon dioxide layer 24, a layer of titanium 26, a first platinum electrode 28, a layer 30 of layered superlattice material, and a second platinum electrode 32. These capacitor devices were tested, with results as shown in Figs. 6A through 22D; a typical result, Figs. 6A and 6B, reveals a material, strontium bismuth tantalate ($SrBi_2Ta_2O_9$), that has almost no fatigue at all after $10^{10}$ cycles.

As sample after sample of the layered-perovskite materials that were ferroelectric proved to have lower fatigue than previously measured for non-layered ferroelectrics, it was realized that there was something common to these materials that gave rise to the low fatigue. While the layered nature of the materials leads to a more uniform distribution of the space charge throughout the layered ferroelectrics, the charge-based arguments mentioned above, when examined thoroughly, do not account for the low fatigue. It is now believed that the non-ferroelectric layers act as "shock absorbers" for the ferroelectric layers. To see this, one must understand that the ferroelectric property is caused by a non-uniform charge distribution within the individual unit cell of the ferroelectric lattice, and this non-uniformity of charge can only be maintained because the ferroelectric crystal lattice is an uncommonly rigid one. When the crystal is forced to switch its polarization state over and over again, this rigidity breaks down and the polarizability decreases to the point that the material is not useable in a memory. In the layered superlattice materials, the non-ferroelectric layer is made of a material, such as $(BiO3)^{-2}$, which has a less rigid lattice structure than the ferroelectric. Since the material alternates with the ferroelectric material, the result is alternate layers of the rigid ferroelectric and the less rigid non-ferroelectric. Thus the less rigid non-ferroelectric absorbs the shocks caused by repeated switching and allows the ferroelectric to maintain its highly polarizable state.

The above explanation immediately leads to a realization of why in over thirty years of extensive research, nobody found a ferroelectric with high polarizability that had low fatigue. Without the shock absorber, the very thing that causes the high polarizability, the rigid crystal structure, also leads to fatigue.

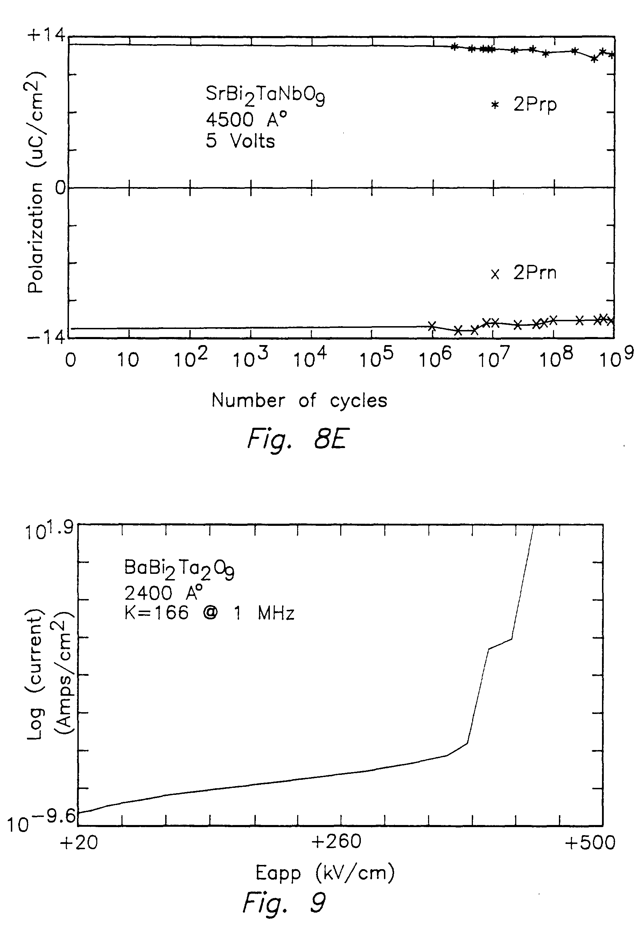

High dielectric constant materials also have crystal lattices that are relatively rigid. Thus an understanding of the layered superlattice structure suggests the layered superlattice materials that are not ferroelectric may be high dielectric constant materials that do not degrade or breakdown over long periods of use. This also turns out to be generally true. Further many of these materials have low leakage currents which is highly desirable for integrated circuits. DC leakage current curves and dielectric constants for some layered superlattice materials are shown in Figs. 9, 10 and 11.

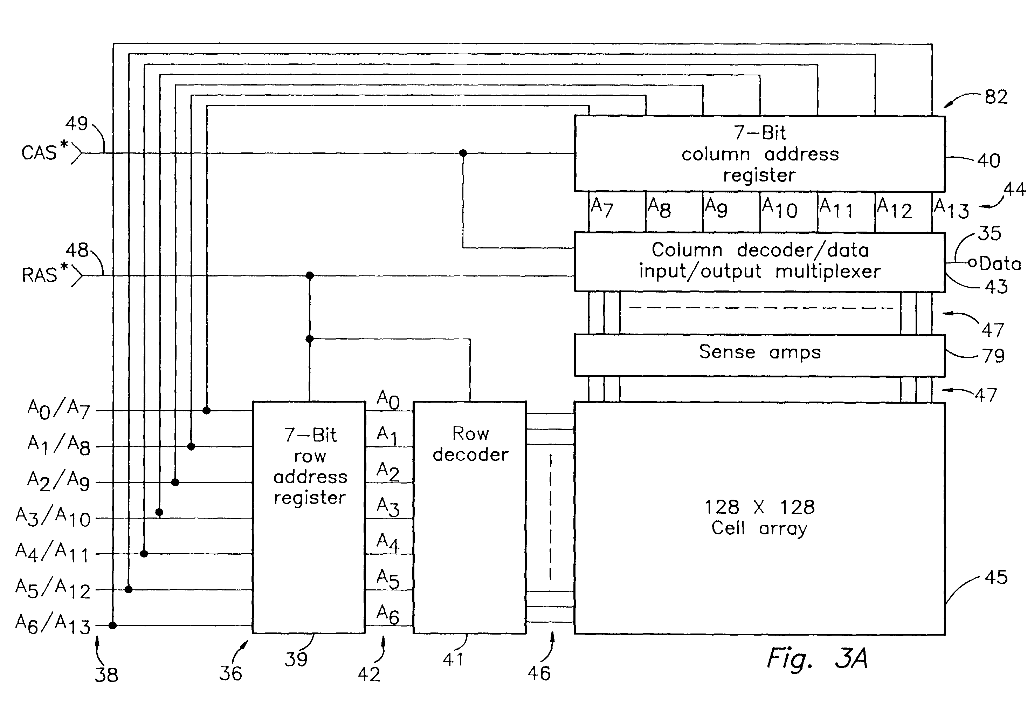

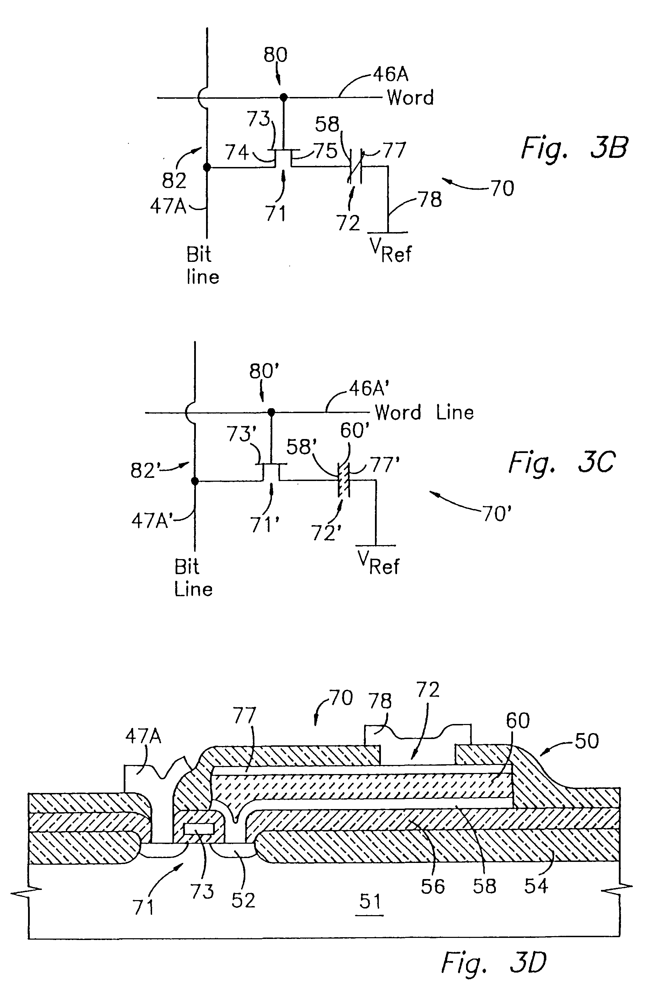

Some of the layered superlattice materials are not compatible with some conventional integrated circuit processes and materials. For example, titanium rapidly diffuses into silicon and forms titanium silicide, thus any of the superlattice materials that include titanium, such as $SrBi_4Ti_4O_{15}$, are preferably utilized with buffer layers, as shown in Fig. 1b. However, many layered superlattice materials are highly compatible with conventional integrated circuit materials. For example, strontium bismuth tantalate ($SrBi_2Ta_2O_9$) and barium bismuth tantalate ($BaBi_2Ta_2O_9$) are highly compatible with most conventional integrated circuit materials and processes. The former is a low fatigue ferroelectric that lends itself to switching capacitors having structures as illustrated in Fig. 2 and non-volatile integrated circuit memories as illustrated in Figs. 3A, 3B and 3D, and the latter is a high dielectric constant material that lends itself to capacitor structures as illustrated in Fig. 2 and volatile integrated circuit memories as illustrated in Figs. 3A, 3C, and 3D.

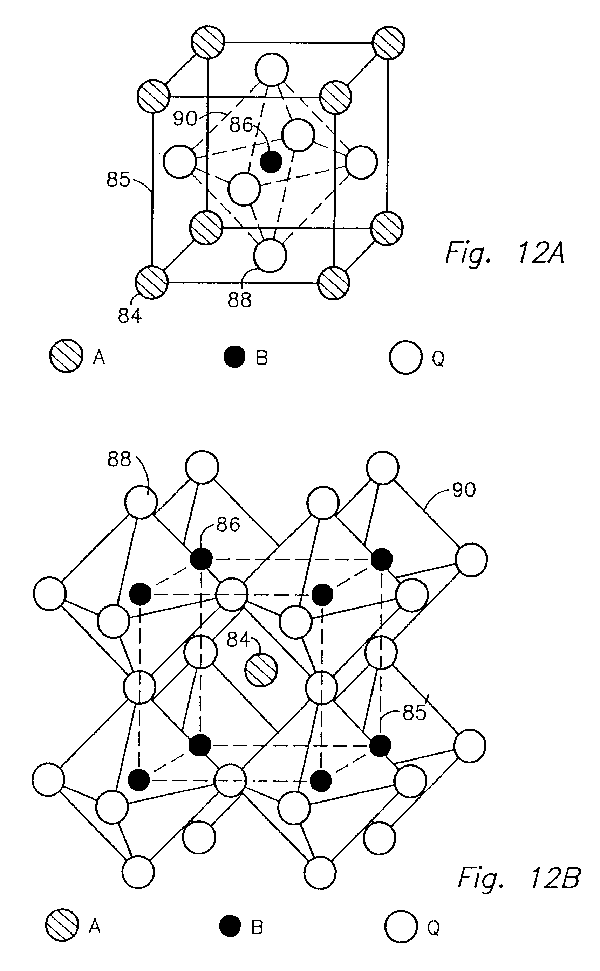

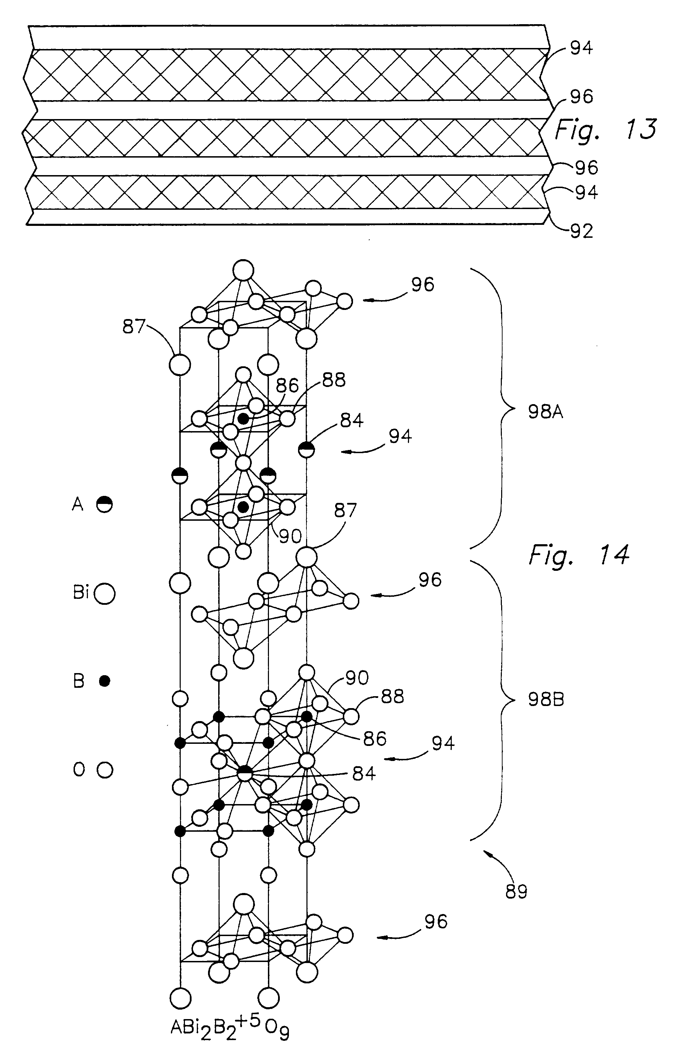

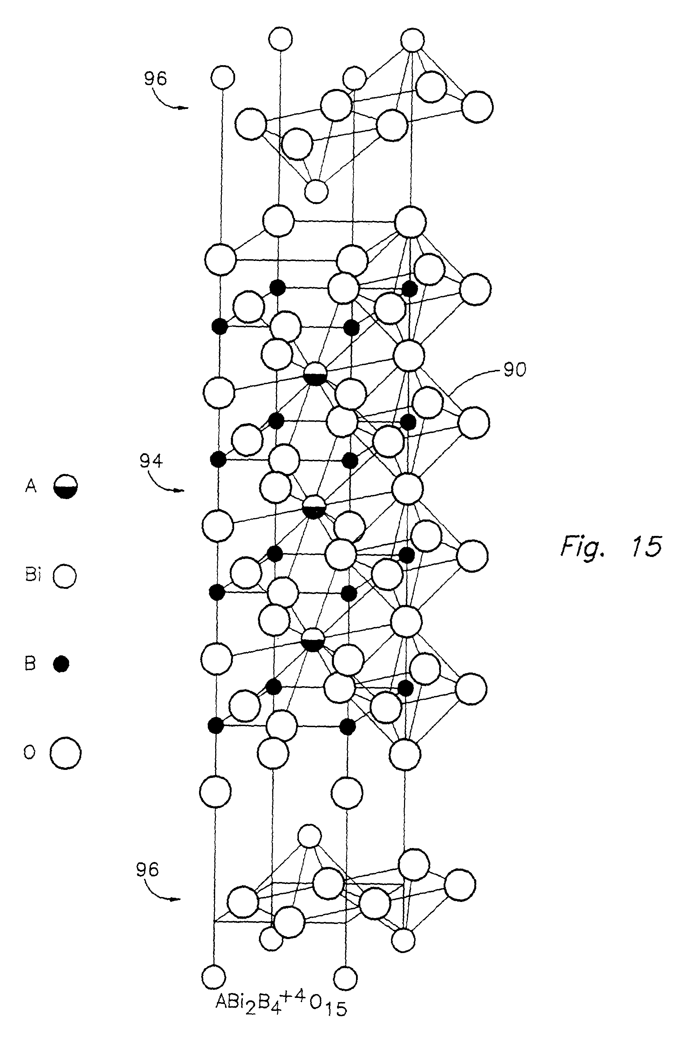

It is well-known that compounds having the perovskite structure may be described in terms of the general formula $ABQ_3$, where A and B are cations and Q is an anion. In the prior art, the formula ABQ3 is usually represented as $ABO_3$, or sometimes $ABX_3$, but we shall use $ABQ_3$ since it is more general than $ABO_3$ and the X may cause confusion with other x's that are used in the most general formula for a layered perovskite. A primitive perovskite unit cell as conventionally represented in the literature is shown in Fig. 12A. In terms of this depiction of the unit cell, the perovskite structure is cubic, with the A cations 84, also called the A-site elements, located at the corners of the cube and generally being elements of relatively large size and small valence, and with the B cations 86, also called the B-site elements, located at the center of the cube and generally being elements of relatively small size and large valence, and the anions 88, located at the face centers of the cube. Another depiction of the perovskite unit cell, which is not a primitive cell but is more useful for purposes of the invention, is shown in Fig. 12B. In this depiction it is more obvious that the perovskite structure comprises corner-linked octahedrons 90, with the anions 88 at the corners of the octahedrons 90, the B cations 86 being at the centers of the octahedrons 90, and the A cations 84 in the spaces between the octahedrons 90. A cube 85' which helps clarify the position of the B-site atoms is shown by dotted lines in Fig. 12B, and the octahedron 90 is shown by dotted lines in Fig. 12A. From the depiction of the unit cell in Fig. 12B, it is easy to see how the octahedrons 90, which each have a dipole moment which causes the ferroelectric character of the material, might be able to move slightly as the polarization switches if their upper and lower "points" were attached to a material more flexible than the lattice of a ferroelectric material. Turning to Fig. 13, a layered superlattice material 92 is illustrated. Smolenskii recognized that what we call the layered superlattice materials spontaneously form into layers 94 with a perovskite-like structure which alternate with layers 96 having a simpler structure. See Smolens kii, G.A., Isupov, V.A. and Agranovskaya A.I.: "Ferroelectrics of the Oxygen-Octahedral Type with Layered structure", Soviet Physics-Solid State, vol.3, No.3, Sept. 1961, pp 651-655. Depending on the material, the perovskite-like layers 94 may include one or a plurality of linked layers of perovskite-like octahedrons 90. As an example, Fig. 14 shows a unit cell 89 of the material $ABi_2B^{+5}_2O_9$, which is the formula for strontium bismuth tantalate ($SrBi_2Ta_2O_9$) and other layered superlattice materials, such as tantalum, niobium, and tungsten, having a element with a valence of +5 in the B-site 86. In this structure, each perovskite-like layer 94 includes two layers of octahedrons 90 which are separated by layers 96 of a material that does not have a perovskite-like structure. In this material the primitive unit cell 89 consists of two perovskite layers 94, each having A-site elements 84, B-site elements 86, and anions 88, and two non-perovskite layers 96 having superlattice generator element 87, since the structure shifts between the layers 98A and 98B. In Fig. 15 the structure for a layered superlattice material having the formula $ABi_2B^{+4}_4O_{15}$, which is the formula for strontium bismuth titanate ($SrBi_4Ti_4O_{15}$) and other layered superlattice materials having an element, such as titanium, hafnium, and zirconium, having a valence of +4 in the B-sites. In this material each the perovskite-like layer 94 has four layers of octahedrons 90.

As the understanding of what Smolenskii called a layered perovskite-like structure increased, the inventors have realized that these materials are more than a substance which spontaneously forms in layers. This is seen most easily by an example. Strontium bismuth tantalate ($SrBi_2Ta_2O_9$) can be considered to be a combination of a material having the formula $Bi_2O_3$ and a material having the formula $SrTa_2O_6$. $SrTa_2O_6$ has a tungsten bronze structure by itself, but within the layered material 92 has a perovskite structure. Thus the layered structure is in reality a superlattice in which the structures of the individual sublattices of the perovskite layers 94 and the non-perovskite layers 96 are interdependent. Hence we refer to these materials herein as "layered superlattice" materials.

The word "superlattice" herein may mean something slightly different than it means in some physics contexts, such as superconductivity. Sometimes the word "superlattice" carries with it connotations of single crystal structures only. However, the materials according to the invention are not always single crystals, in fact none of the materials produced to date are single crystals, though it is believed that single crystals of these materials can be made. The materials of the invention work well in the polycrystalline state. In the polycrystalline state, the structure of the materials includes grain boundaries, point defects, dislocation loops and other microstructure defects. However, within each grain, the structure is predominately repeatable units containing one or more ferroelectric layers and one or more intermediate non-ferroelectric layers spontaneously linked in a interdependent manner. Thus the layered superlattice materials of the invention which are ferroelectric can be defined as: (A) a material having a localized structure, within a grain or other larger or smaller unit, which localized structure contains predominately repeatable units containing one or more ferroelectric layers and one or more intermediate non-ferroelectric layers spontaneously linked in an interdependent manner. The invention also includes materials that are not ferroelectric, and these can be included in the following definition: (B) a material having a localized structure, within a grain or other larger or smaller unit, which localized structure contains predominately repeatable units containing one or more perovskite-like layers and one or more intermediate non-perovskite-like layers spontaneously linked in an interdependent manner.

It has been discovered that the layered superlattice materials catalogued by Smolenskii et al. are all likely candidates for fatigue free switching ferroelectrics and dielectric materials that are resistant to degradation and breakdown over long periods of use. Rather than being random solid solutions following the general formula $ABO_3$, these materials follow the formulae outlined by Smolenskii:

(I) compounds having the formula $A_{m-1}Bi_2M_mO_{3m+3}$, where A = $Bi^{3+}$, $Ba^{2+}$, $Sr^{2+}$, $Ca^{2+}$, $Pb^{2+}$, $K^+$, $Na^+$ and other ions of comparable size, and M = $Ti^{4+}$, $Nb^{5+}$, $Ta^{5+}$, $Mo^{6+}$, $W^{6+}$, $Fe^{3+}$ and other ions that occupy oxygen octahedral; this group includes bismuth titanate, $Bi_4Ti_3O_{12}$;

(II) compounds having the formula $A_{m+1}M_mO_{3m+1}$, including compounds such as strontium titanates $Sr_2TiO_4$, $Sr_3Ti_2O_7$ and $Sr_4Ti_3O_{10}$; and

(III) compounds having the formula $A_mM_mO_{3m+2}$, including compounds such as $Sr_2Nb_2O_7$, $La_2Ti_2O_7$, $Sr_5TiNb_4O_{17}$, and $Sr_6Ti_2Nb_4O_{20}$. It is noted that in the case of $Sr_2Nb_2O_7$ and $La_2Ti_2O_7$ the formula needs to be doubled to make them agree with the general formula.

The materials of the invention include all of the above materials plus combinations and solid solutions of these materials. The materials may be summarized more generally under the formula:

$$(1) \qquad A1^{+a1}_{w1}A2^{+a2}_{w2}...Aj^{+aj}_{wj}S1^{+s1}_{x1}S2^{+s2}_{x2}...Sk^{+sk}_{xk}B1^{+b1}_{y1}B2^{+b2}_{y2}...Bl^{+bl}_{yl}Q^{-2}_z ,$$

where A1, A2...Aj represent A-site elements in the perovskite-like structure, which may be elements such as strontium, calcium, barium, bismuth, lead, and others S1, S2...Sk represent super-lattice generator elements, which usually is bismuth, but can also be materials such as yttrium, scandium, lanthanum, antimony, chromium, thallium, and other elements with a valence of +3, B1, B2...BI represent B-site elements in the perovskite-like structure, which may be elements such as titanium, tantalum, hafnium, tungsten, niobium, zirconium, and other elements, and Q represents an anion, which generally is oxygen but may also be other elements, such as fluorine, chlorine and hybrids of these elements, such as the oxyfluorides, the oxychlorides, etc. The superscripts in formula (1) indicate the valences of the respective elements, and the subscripts indicate the number of moles of the material in a mole of the compound, or in terms of the unit cell, the number of atoms of the element, on the average, in the unit cell. The subscripts can be integer or fractional. That is, formula (1) includes the cases where the unit cell may vary throughout the material, e.g. in $Sr_{.75}Ba_{.25}Bi_2Ta_2O_9$, on the average, 75% of the time Sr is the A-site atom and 25% of the time Ba is the A-site atom. If there is only one A-site element in the compound then it is represented by the "A1" element and w2...wj all equal zero. If there is only one B-site element in the compound, then it is represented by the "B1" element, and y2...yl all equal zero, and similarly for the superlattice generator elements. The usual case is that there is one A-site element, one superlattice generator element, and one or two B-site elements, although formula (1) is written in the more general form since the invention is intended to include the cases where the A or B sites and the superlattice generator can have multiple elements. The value of z is found from the equation:

$$(2) \qquad (a1w1 + a2w2...+ajwj) + (s1x1 + s2x2...+skxk) + (b1y1 +b2y2...+ blyl) = 2z.$$

Formula (1) includes all three of the Smolenskii type compounds: for the type I material, w1 = m - 1, x1 = 2, y1 = m, z = 3m + 3 and the other subscripts equal zero; for the type II material, w1 = m + 1, y1 = m, z = 3m + 1, and the other subscripts equal zero; for the type III material, w1 = m, y1 = m, z = 3m + 2, and the other subscripts equal zero. It is noted that the Smolenskii type I formula does not work for M = Ti and m = 2, while the formula (1) does work. This is because the Smolenskii formula does not consider valences. The materials according to the invention do not include all materials that can be fit into formula (1), but rather only those materials that spontaneously form layered superlattices. In summary, the materials of the invention include all the layered superlattice materials as described by the definitions (A) and (B) above, the Smolenskii formulas, and the formula (1), plus solid solutions of all the foregoing materials.

An exemplary wafer 1 on which test samples of capacitor devices according to the invention have been fabricated is shown in Fig. 1A. It should be understood that the Figs. 1A, 1B, and 2 depicting capacitor devices 1, 20 and Fig. 3D depicting an integrated circuit device 50 are not meant to be actual plan or cross-sectional views of any particular portion of an actual capacitor or integrated circuit device, but are merely idealized representations which are employed to more clearly and fully depict the structure and process of the invention than would otherwise be possible. Fig. 1B shows a cross-section of the wafer 1 of Fig. 1A taken through the line 1B - 1B. Fig. 2 depicts a similar cross-section taken through a wafer similar to that of Fig. 1A but having a different layered structure. Referring to Figs. 1A and 1B, the wafer 1 preferably comprises a P-type silicon substrate 2 on which an approximately 5000 Å silicon dioxide insulating layer 4 has been wet grown. A thin layer 6 of titanium metal has been deposited on the silicon dioxide 4, preferably by sputtering in situ, and a 2000 Å thick electrode of platinum has been deposited on the titanium 6, preferably by sputtering in situ. By "in situ" is meant that both the titanium and the platinum are sputtered without breaking vacuum. The titanium diffuses into the silicon dioxide and platinum and assists the platinum 8 in adhering to the silicon dioxide 4, and is optional. A buffer layer 10, is deposited on the platinum electrode 8, followed by a layer 12 of a layered superlattice material according to the invention, followed by another buffer layer 14, via processes that will be described in detail in the Examples below. Another 2000 Å layer of platinum is deposited on the buffer layer 14. The wafer 1 is annealed, patterned with a photo-mask process, and etched down to the electrode layer 8 to produce rectangular capacitor devices 17A,17B, etc. (Fig. 1A) of various sizes separated by large areas of the electrode 8. The size of the devices 17A, 17B, etc. is greatly exaggerated in Fig. 1A. Each device 17A, 17B, etc. may be tested by connecting one lead of the test device to the platinum electrode layer 8 and contacting the other electrode layer 16 of the particular device 17A, 17B, etc. with a fine probe connected to the other lead of the test device. Devices having the cross-sectional structure of Fig. 2 are similarly fabricated except that the two buffer layers 10, 12 are not deposited. That is, the wafer of Fig. 2 includes a silicon substrate 22, a silicon dioxide layer 24, an optional titanium layer 26, a first platinum electrode 28, a layered superlattice material layer 30, and a second platinum electrode 32. The wafer 20 is similarly pattered to form capacitor devices of various sizes having the cross-section shown in Fig. 2. The fabrication of exemplary devices of the types shown in both Figs. 1 B and 2 will be described in detail in the Examples below.

Fig. 3A is a block diagram illustrating an exemplary integrated circuit memory 36 in which ferroelectric switching capacitors or high dielectric constant capacitors made with the materials of the invention are utilized. For simplicity, the embodiment shown is for a 16K X1 DRAM; however the material may be utilized in a wide variety of sizes and types of memories, both volatile and non-volatile. It should be noted that memory 36 is intended to represent both a volatile and non-volatile memory; the memory 36 will be non-volatile if the memory cells 45 comprise non-volatile memory cells 70 (Fig. 3B) and will be volatile if the memory cells 45 comprise volatile cells 70' (Fig. 3C). In the 16K embodiment shown, there are seven address input lines 38 which connect to a row address register 39 and a column address register 40. The row address register 39 is connected to row decoder 41 via seven lines 42, and the column address register 40 is connected to a column decoder/data input output multiplexer 43 via seven lines 44. The row decoder 41 is connected to a 128 X 128 memory cell array 45 via 128 lines 46, and the column decoder/data input output multiplexer 43 is connected to the sense amplifiers 79 and memory cell array 45 via 128 lines 47. A RAS* signal line 48 is connected to the row address register 39, row decoder 41, and column decoder/data input/output multiplexer 43, while a CAS* signal line 49 is connected to the column address register 40 and column decoder/data input output multiplexer 43. (In the discussion herein, a * indicates the inverse of a signal.) An input/output data line 35 is connected to the column decoder/data input output multiplexer 43.

Memory cell array 45 contains 128 x 128 = 16,384 memory cells, which is conventionally designated as 16K. These cells may be ferroelectric switching capacitor-based cells or dielectric capacitor-based cells. A ferroelectric capacitor-based switching cell 70 is shown in Fig. 3B. The cell includes two electrically interconnected electrical devices: a transistor 71 and a ferroelectric switching capacitor 72. The gate 73 of transistor 71 is connected to line 46A, which is one of the lines 46 (Fig. 3A) which are generally called "word lines". Source/drain 74 of transistor 71 is connected to line 47A, which is one of lines 47 which are generally called "bit lines". The other source/drain 75 of transistor 71 is connected to electrode 58 of switching capacitor 72. The other electrode 77 of switching capacitor 72 is connected to line 78 which is connected to a reference voltage $V_{ref}$. The cell 70 may be fabricated as an integrated circuit 50 as shown in Fig. 3D. The individual elements just described in connection with Fig. 3B are labeled with the same numbers in Fig. 3D.

A dielectric capacitor-based memory cell 70'is shown in Fig. 3C. All the parts 46', 47', 71', 73', 58', 77' etc. of this cell 70' correspond to the parts having the same number (without a "'") in Fig. 3B, although the specifications (threshold voltage of the transistor 71', reference voltage, etc.) may be different, and the capacitor 72' contains a dielectric layered superlattice material 60' instead of a ferroelectric switching material. That is, material corresponding to layered superlattice layer 60 (Fig. 3D) in the integrated circuit implementation will be one of the high dielectric constant materials of the invention rather than one of the low-fatigue ferroelectric switching materials; the cell 70' may be implemented in an integrated circuit 50 as shown in Fig. 3D, with the elements in Fig. 3D having a particular number corresponding to the elements in Fig. 3C having the same number with a "'".

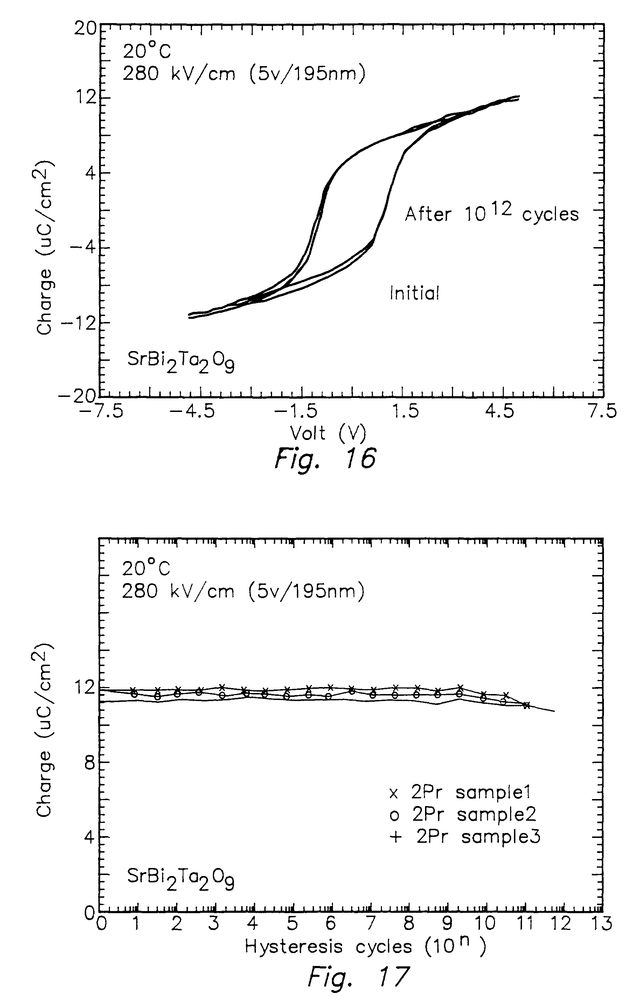

The operation of the memory in Figs. 3A through 3D is as follows. Row address signals $A_0$ through $A_6$ (Fig. 3A) and column address signals $A_7$ through $A_{13}$ placed on lines 38 are multiplexed by via address registers 39, 40 and the RAS* and CAS* signals to the row decoder 41 and column decoder/data input/output multiplexer 43, respectively. The row decoder 41 places a high signal on the one of the wordlines 46 that is addressed. The column decoder/data input output multiplexer 43 either places the data signal on line 35 on the one of the bit lines 47 corresponding to the column address, or outputs on the data line 35 the signal on the one of the bit lines 47 corresponding to the column address, depending on whether the function is a write or read function. As is known in the art, the read function is triggered when the RAS* signal precedes the CAS* signal, and the write function is triggered when the CAS* signal comes before the RAS* signal. The transistors 71, 71' in the cells connected to the word line that is high turn on, permitting the data signal on the bit line 47A, 47A' to be read into the capacitor 72, 72' or the signal on the capacitor 72, 72' to be output on the bit line 47A, 47A' depending on whether the read or write function is implemented. As is well-known in the art, the sense amplifiers 79 are located along lines 47 to amplify the signals on the lines. Other logic required or useful to carry out the functions outlined above as well as other known memory functions is also included in the memory 36 but is not shown or discussed as it is not directly applicable to the invention. As outlined above, the RAS* and CAS* lines 48 and 49, registers 39, 40, the decoders 41, 42, and the transistor 71 comprise an information write means 80 for placing the memory cell 70 in a first memory state or a second memory state depending upon information input to the memory on data line 35, the first memory cell state corresponding the layer 60 of ferroelectric layered superlattice material being in a first polarization state, and the second memory cell state corresponding to the layer 60 being in a second polarization state; these components plus sense amplifiers 79 comprise an information read means 82 for sensing the state of memory cell 70 and providing an electrical signal corresponding to the state. Test cells made with strontium bismuth tantalate ($SrBi_2Ta_2O_9$) as the layered superlattice material have held their polarization states for over 80 days at 100°C and other conditions of shock and stress. See the discussion below in connection with Figs. 16 through 22D.

Similarly, the RAS* and CAS* lines 48 and 49, registers 39, 40, the decoders 41, 42, and the transistor 71' comprise an information write means 80' for placing the capacitor 72' in a first charge state or a second charge state depending upon information input to the memory on data line 35; and these components plus sense amplifiers 79 comprise an information read means 82' for sensing the charge state of capacitor 72' and providing an electrical signal corresponding to the charge state.

A detailed example of the fabrication process for an integrated circuit memory cell 50 as in Fig. 3D is given in United States Patent Application Serial No. US 920 919, 186 filed 23.7.1992. Several examples of the process of fabricating a layered superlattice material and capacitor devices as shown in Figs. 1A through 2 are given below. Each is preceded by a table listing the reactive components utilized in the fabrication process. The solvents used are described in a description of the process following each table. In the tables, "FW" indicates formula weight, "g" indicates grams, "mmoles" indicates millimoles, and "Equiv." indicates the equivalent number of moles in solution. "Xylenes" indicates a commercially available xylene solution which includes three different fractionations of xylene. Bismuth 2-ethylhexanoate indicates a commercially available bismuth solution of bismuth 2-ethylhexanoate in 74% naphtha; the formula weight in this case is placed in parenthesis to indicate that it is an equivalent formula weight of bismuth in the solution as a whole, rather than the formula weight of the just the bismuth 2-ethylhexanoate, in order to take into account the presence of the naphtha. All processes were performed at the atmospheric pressure in Colorado Springs, Colorado, except where otherwise noted. In the examples below, all the initial wafer substrates on which the materials described were fabricated were layered substrates as illustrated by layers 2, 4, 6, and 8 in Fig. 1 B or layers 22, 24, 26, and 28 in Fig. 2, with the silicon substrates 2, 22 being made of P-type silicon of between 5 Ohms/cm and 25 Ohms/cm resistivity, having a field oxide layer 4, 24 that was wet grown to about 5000Å, a 200 Å thick layer 6, 26 of sputtered titanium, and a 2000 Å layer 8, 28 of sputtered platinum. After the layers 10, 12, 14 and 16, for the samples that had buffer layers, or the layers 30 and 32 for the samples that did not have buffer layers, were deposited as described in the examples, the wafer was patterned as illustrated in Fig. 1A using either a positive or negative photo resist in combination with a photo mask step. When an IPC strip is indicated, this is an oxygen plasma strip using an Ion Plasma Corporation "barrel etcher" at 500 mTorr oxygen and 350 watts (1 Torr = 133.32 Nm$^{-2}$). When an rapid thermal process (RTP) is indicated, the process was done with an AG Associates model 410 Heat Pulser, the ramp rate given is for the period of increasing the temperature to the working temperature, and the time period given is the time for which the temperature was held at the working temperature. In all cases an oxygen flow of 3 liters/minute is used in the RTP anneals.

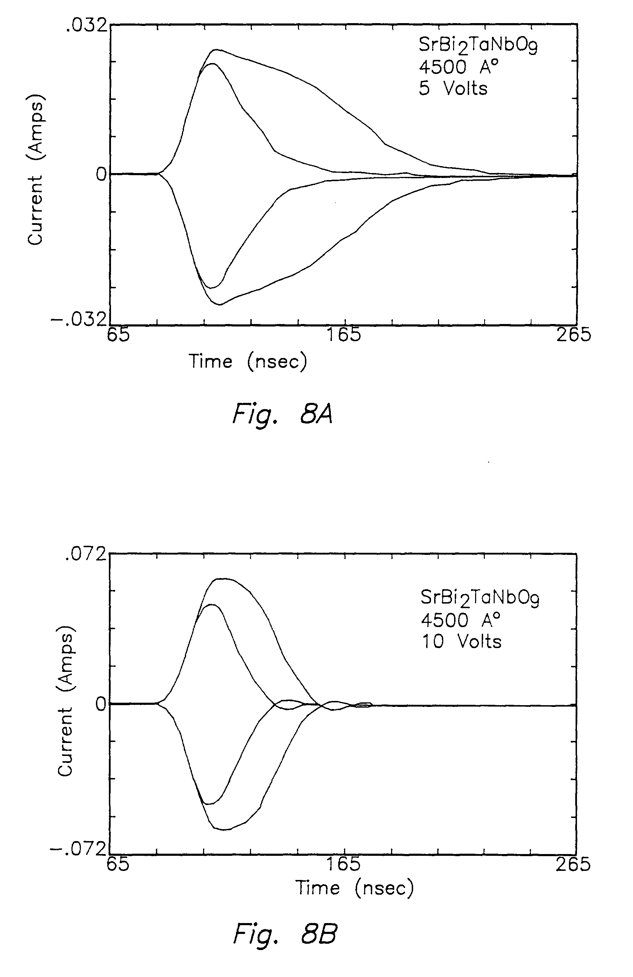

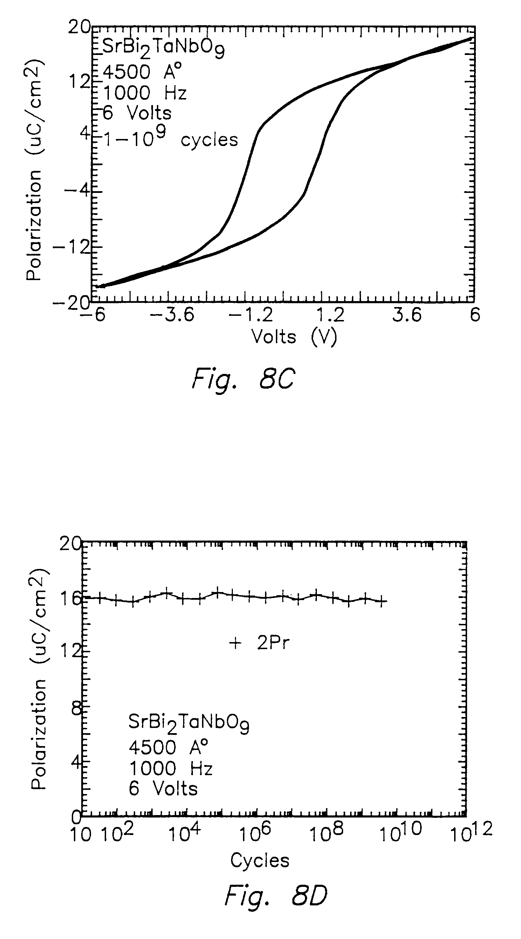

Following each example of the detailed fabrication process, is a discussion of the electrical properties of the sample as illustrated in the figures. In addition, the electrical properties of numerous other samples fabricated in a similar manner are also discussed in relation to the figures. In each figure, the material of the sample, the thickness of the sample, and other relevant parameters are given. The thickness is usually approximate since, as in all layering type processes, the thickness can vary, and it was not measured for each portion of the wafer. For some samples, the given thickness is based on the known thickness that results from the processing parameters; the measurements of thickness that were done confirmed that the thicknesses did not vary sufficiently from that determined from the process parameters to alter the results significantly. The figures include hysteresis curves, such as Fig. 5A, PUND switching curves, such as Fig. 8A, material endurance or "fatigue" curves such as Fig. 4 and Fig. 6A, and leakage current curves, such as Fig. 9. The hysteresis curves are given in terms of the applied electric field in kilovolts per centimeter versus the polarization in microcoulombs per centimeter squared, except for those of Figs. 6B and 8C where the abscissa is in volts. As is well-known, hysteresis curves which suggest good ferroelectric properties tend to be relatively boxy and long in the direction of polarization, the ordinate in the figures herein, as for example the curve in Fig. 6B, rather than thin and linear. The hysteresis measurements were all made on an uncompensated Sawyer-Tower circuit unless otherwise noted. The PUND switching curves are given in terms of current in amps or amps/cm$^2$ along the ordinate versus time in nanoseconds along the abscissa. The PUND curves are generated in a well-known manner. For a standard architecture of a memory cell (but not for all architectures) the PUND curves indicate the suitability of the material for a non-volatile ferroelectric switching memory application. Generally, it is desirable that the "P" and "N" curves are well-separated from the "U" and "D" curves, respectively, which provides a large signal in the standard architecture. It is also desirable that all the curves fall quickly to a low value; a curve that falls quickly indicates that the material completes the current flow, which produces the signal, quickly, that is, it is a "fast switching" material. Generally, in the tests herein, the switching time is taken to be the time to fall to a value of 10% of the maximum amplitude, since this 10% level will generally be within the noise level of a typical integrated circuit. The endurance or "fatigue" curves give the polarization, one of either $P_r^+$, $P_r^-$, Prp or Prn, in microcoulombs per square centimeter versus the number of cycles. These curves are of two types: one type, such as Fig. 4, is taken from the polarizabilities measured in a hysteresis measurement, and the other type, such as Fig. 6A, is taken from the polarizabilities measured in a PUND switching test. The leakage current curves, such as Fig. 9, are given in terms of the applied electric field as the abscissa versus the log of the current in amps per square centimeter. It is necessary to use the log of current because the curves are measured over an extremely wide range of currents. A leakage current of $10^{-6}$ amps per square centimeter or less is considered excellent for dielectric applications. However, it should be kept in mind that for a given material the leakage current can be decreased simply by making the material thicker, and will be increased if the material is made thinner. Thus the thickness of the material on which the measurement is made must be considered. In state-of-the-art high-density CMOS integrated circuits, the dielectric layers range from about 100 Å for the capacitor dielectric in DRAM capacitors to about 15,000 Å for passivation layers.

Turning now to the specific examples of devices fabricated of the layered superlattice material, as mentioned above, a device a shown in Fig. 1B having a layer 12 of bismuth titanate between buffer layers 19, 14 of strontium

titanate ($SrTiO_3$) was fabricated as follows. First, the compounds shown in Table I were measured. The bismuth 2-ethylhexanoate was placed in 90 ml xylenes. The solution

TABLE I

| Compound | FW | g | mmole | Equiv. |
|---|---|---|---|---|
| Bismuth 2-ethylhexanoate | (638.61) | 21.2578 | 24.6328 | 4.00000 |
| Titanium Isopropoxide | 284.26 | 5.2517 | 18.4750 | 3.00006 |
| Strontium | 87.62 | 2.8023 | 31.982 | 1.0000 |
| 2-ethylhex-anoic acid | 144.21 | 9.2283 | 63.992 | 2.0009 |
| Titanium Isopropoxide | 284.26 | 9.0912 | 31.982 | 1.0000 |

was stirred and heated to a maximum temperature of 117°C to distill out all light hydrocarbon fractions and water. The first measure of titanium isopropoxide was combined with 60 ml of 2-methoxyethanol, and was stirred and heated to a maximum temperature of 116°C to distill out all water and isopropanol. The bismuth solution and the titanium solution were combined, then heated to a maximum temperature of 136°C to distill out all 2-methoxyethanol and some xylenes until 60 ml of solution remained. The concentration was 0.1206 moles of $Bi_4Ti_3O_{12}$ per liter with .002% excess titanium.

The strontium was placed in the 2-ethylhexanoic acid together with 50 ml 2-methoxyethanol. The solution was stirred and heated to a maximum temperature of 115°C to distill off all light hydrocarbon fractions and water. The second measure of titanium isopropoxide was dissolved in 50 ml methoxyethanol and stirred and heated to a maximum of 115°C to distill off the isopropanol and water. The strontium and titanium solutions were combined and stirred and heated to a maximum temperature of 125°C to distill down to a volume of 60.0 ml. The concentration was 0.533 moles of $SrTiO_3$ per liter. Just prior to use, a xylene exchange was performed by adding 25 ml of xylenes to 5 ml of the above $SrTiO_3$ solution and stirred and heated to a maximum temperature of 128°C to distill out 7 ml to produce a final solution of 23 ml volume and a concentration of .116 moles of $SrTiO_3$ per liter.

The wafer was baked at 140°C in air for 30 minutes to dehydrate it. An eyedropper was used to place 1 ml of the $SrTiO_3$ solution on a wafer as in Fig. 1 B with the layers deposited up to and including the platinum bottom electrode 8. The wafer was spun at 1500 RPM for 20 seconds. The wafer was then placed on a hot plate and baked at 250°C in air for four minutes to form layer 10. An eyedropper was used to place 1 ml of the $Bi_4Ti_3O_{12}$ solution on the wafer and the wafer was spun at 1500 RPM for 20 seconds. The wafer was placed on a hot plate and baked at 250°C for 4 minutes to form layer 12. The steps from using an eyedropper to deposit 1 ml of $SrTiO_3$ solution on the wafer through baking on the hot plate were repeated for another $SrTiO_3$ layer 14. The wafer was then transferred to a diffusion furnace and annealed at 700°C in an oxygen flow of 5 liters/minute for 50 minutes. The top layer 16 of 2000 Å platinum was sputtered, a resist was applied, followed by a standard photo mask process, an ion mill etch, an IPC strip and a final contact anneal at 700°C in an oxygen flow of 5 l/m for 50 minutes. The resulting sample was tested with the results shown in Fig. 4. Fig. 4 shows that $P_r^-$ and $P_r^+$ remain almost unchanged all the way out past $10^9$ cycles. Thus, whatever is exhibiting the hysteresis is a very low-fatigue material. As mentioned above, it is currently believed that the $SrTiO_3$ and the $Bi_4Ti_3O_{12}$ interdiffused at their interfaces and that the low fatigue results were that of a thin layer of material such as strontium bismuth titanate ($SrBi_4Ti_4O_{15}$).

In a similar manner as described above, a device as shown in Fig. 1B was fabricated having a layer 12 of strontium bismuth titanate ($SrBi_4Ti_4O_{15}$) between buffer layers 10, 14 of strontium titanate ($SrTiO_3$). This sample was tested with the results shown in Figs. 5A and 5B. Fig. 5A shows the initial hysteresis curve for the $SrTiO_3/SrBi_4Ti_4O_{15}/SrTiO_3$ layered material, and Fig. 5B shows the hysteresis curve after $10^{10}$ cycles. This is clearly a low-fatigue ferroelectric structure, since the hysteresis curve changed only slightly. Moreover, the hysteresis curve is fat and perpendicular, resulting in a relatively large Pr.

As a third example, a ferroelectric capacitor device as shown in Fig. 2 having a ferroelectric layer 30 made of strontium bismuth tantalate ($SrBi_2Ta_2O_9$) was fabricated as follows. First, the compounds shown in Table II were measured.

TABLE II

| Compound | FW | g | mmole | Equiv. |
|---|---|---|---|---|
| Tantalum ethoxide | 406.26 | 4.9553 | 12.197 | 2.0000 |
| 2-ethylhex-anoic acid | 144.21 | 8.7995 | 61.019 | 10.006 |
| Strontium | 87.62 | 0.5330 | 6.0831 | 0.9975 |

TABLE II   (continued)

| Compound | FW | g | mmole | Equiv. |
|---|---|---|---|---|
| 2-ethylhex-anoic acid | 144.21 | 1.7613 | 12.213 | 2.0026 |
| Bismuth 2-ethylhexanoate | (862.99) | 10.525 | 12.196 | 1.9998 |

The strontium was combined with the first measure of 2-ethylhexanoic acid and 80 ml 2-methoxyethanol. The mixture was stirred on low heat of between about 70°C and 90°C to hurry the reaction rate. When all the strontium was reacted and the solution had cooled to approximately room temperature, the tantalum ethoxide followed by the second measure of 2-ethylhexanoic acid were added. The mixture was stirred and heated to a maximum temperature of 115°C to distill out ethanol and water. Then 75 ml xylenes followed by the bismuth 2-ethylhexanoate were added. The solution was stirred and heated with a maximum temperature of about 125°C until only 60.0 ml of solution remained. The concentration was 0.102 moles of $SrBi_2Ta_2O_9$ per liter. The wafer was baked at 140°C in air for 30 minutes to dehydrate it. An eyedropper was used to place 1 ml of the $SrBi_2Ta_2O_9$ solution on a wafer as in Fig. 2 with the layers deposited up to and including the platinum bottom electrode 28. The wafer was spun at 1500 RPM for 20 seconds. The wafer was then placed on a hot plate and baked at above 250°C in air for three minutes. The steps from using an eyedropper to deposit solution on the wafer through baking on the hot plate were repeated for another layer. The wafer was then transferred to a diffusion furnace and annealed at 750°C in an oxygen flow of 5 l/m for 2 hours. The top layer 32 of 2000 Å platinum was sputtered, a resist was applied, followed by a standard photo mask process, an ion mill etch, an IPC strip and a final contact anneal at 750°C in an oxygen flow of 5 l/m for 30 minutes. The resulting sample was tested with the results shown in Figs. 6A and 6B. Fig. 6A shows a graph of 2Prp and 2Prn over $10^{10}$ cycles, derived from a PUND switching test. This curve shows negligible fatigue over the entire $10^{10}$ cycles. These results are phenomenal when compared to the prior art materials, and indicate that this layered superlattice material would last indefinitely in a ferroelectric switching memory.

Fig. 6B shows hysteresis curves at 2, 4, 6, 8, and 10 volts for a further sample capacitor of the type shown in Fig. 2 utilizing strontium bismuth tantalate ($SrBi_2Ta_2O_9$) as the ferroelectric material. This capacitor was made in a process as described in the third example above, except that 10% excess bismuth was used in the precursor solution and other process parameters were carefully controlled to ensure better stoichiometry. This hysteresis curve is very boxy and more vertical, and the hysteresis curves for the five different voltages all nearly overlap, with the curves for the higher voltages simply extending out further along approximately the same line. This feature holds great significance for practical integrated circuit devices, since it means that even if the voltage changes substantially from specifications, as often happens in the real world, the device performance will not change significantly. The value of 2Pr was 25.06, the best obtained to date for this material. This value of 2Pr is more than 4 times the value of Ps for strontium bismuth tantalate given in the Lines and Glass reference given above!

As a fourth example, a ferroelectric capacitor device as shown in Fig. 2 having a ferroelectric layer 30 made of strontium bismuth niobate ($SrBi_2Nb_2O_9$) was made in a similar process as described in the third example above. The resulting sample was tested with the results shown in Fig. 7, which is a graph of 2Prp and 2Prn versus number of switching cycles. This shows much lower fatigue than prior art materials, but not as low as that for strontium bismuth tantalate ($SrBi_2Ta_2O_9$) in Fig. 6A, although it is possible that the difference in the fatigue is due to less than optimum processing on this particular sample.

As a fifth example, a ferroelectric capacitor device as shown in Fig. 2 having a ferroelectric layer 30 made of strontium bismuth tantalum niobate ($SrBi_2TaNbO_9$) was made in a similar process as described in the third example above. The resulting sample was tested with the results shown in Figs. 8A through 8E.

The first thing to note is that $SrBi_2TaNbO_9$ is a material with two B-site elements, tantalum and niobium. Fig. 8A shows the PUND switching test results for $SrBi_2TaNbO_9$ at 5 volts and Fig. 8B shows the PUND results at 10 volts. The results at 5 volts are very good, showing excellent differentiation in the switching pulses (the pulses that go most positive and negative) and the dielectric charge pulses (the other two pulses). Moreover, the current falls quickly into the background noise; that is, although there is a long tail on the pulses, the tail is down in the noise. This quick fall off indicates that the material is a relatively "fast" switching material. The results for 10 volts are excellent, again showing good differentiation, and almost no tail, indicating very fast switching. One immediately thinks that if this material has low fatigue, it would be an excellent material for a ferroelectric switching application, such as a memory. Fig. 8C is a graph in which the hysteresis curve at 6 volts was repeated on the same graph paper at 10, 100, 1000, switching cycles etc. up to $10^9$ switching cycles. The curve follows almost exactly the same line, indicating an fatigue that was inconceivable in the prior art. Fig. 8D shows a graph of 2Pr versus number of hysteresis cycles taken from the same data as the curves of Fig. 8C, but going out to $10^{10}$ cycles. Again, there is almost no change over the entire $10^{10}$ cycles. Fig. 8E shows the curves of 2Prp and 2Prn versus switching cycles. While this shows a little more fatigue than the

same curves for $SrBi_2Ta_2O_9$ (Fig. 6A), still the results must be considered to be phenomenal as compared to prior art materials. There is only about 5% fatigue over $10^9$ cycles, which is ten times better than even the best materials in the prior art. The results show that $SrBi_2TaNbO_9$ should provide non-volatile ferroelctric memories that last indefinitely. Moreover, none of the elements in the compound are elements that cause compatibility problems with conventional integrated circuit technologies. It is noted that the voltages of the curves of Figs. 8A through 8E are all within the range of voltages that are common in integrated circuits. This material shows excellent performance at 5 volts, the most common voltage used in integrated circuits, and has good performance all the way down to 2 volts, which shows promise of integrated circuits that can operate at even lower voltages than conventional circuits, which would result in low current consumption, long battery life in circuits that run on batteries, and enhanced reliability of circuit components.

As a sixth example, a capacitor device as shown in Fig. 2 having a layered superlattice material layer 30 made of barium bismuth tantalate ($BaBi_2Ta_2O_9$) was fabricated in a similar process as described in the third example above. The resulting sample was tested with the results shown in Fig. 9.

The $BaBi_2Ta_2O_9$ was not a switching ferroelectric, but was a paraelectric with a dielectric constant of 166 at 1 megahertz. This is a very high dielectric constant as compared to the dielectric constant of 3.9 for silicon dioxide, the most commonly used dielectric in integrated circuits. Fig. 9 shows the leakage current curve for $BaBi_2Ta_2O_9$. At low voltages, the leakage current is negligible, of the order of $10^{-10}$ amps/cm2. Over the range of voltages uses in conventional integrated circuits, i.e. 1-10 volts, the leakage current across the 2400 Å sample remains below about $10^{-8}$ amps/cm$^2$, which is still very small. The thickness of this sample is about the same thickness generally used for dielectrics in conventional integrated circuits. These results show that this material will be an excellent high dielectric material in integrated circuits. Moreover, none of the elements of which the material is composed create compatibility problems with conventional integrated circuit materials. In addition $BaBi_2Ta_2O_9$ should be much more resistant to radiation damage than conventional dielectrics because, except for the oxygen, the elements out of which is compounded are heavier than the elements such as silicon and nitrogen out of which conventional integrated circuit dielectrics are composed.

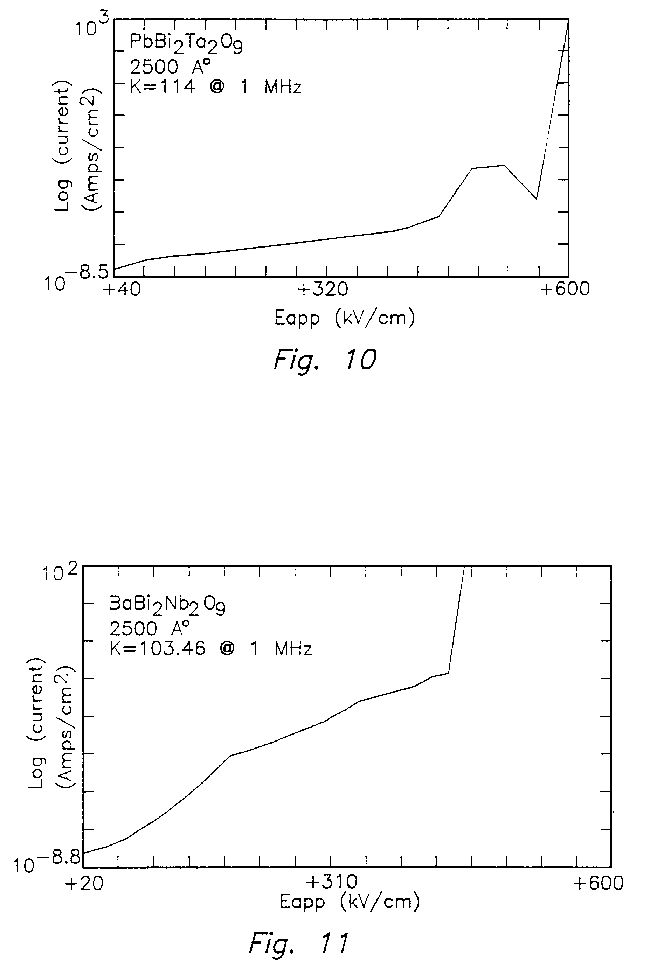

As a seventh example, a capacitor device as shown in Fig. 2 having a layered superlattice material layer 30 made of lead bismuth tantalate ($PbBi_2Ta_2O_9$) was fabricated in a similar process as described in the third example above, except that the lead in the precursor solution was 10% in excess of the stoichiometric amount. This was done to account for the fact that a significant amount of lead goes off as lead oxide vapor during the baking and annealing processes. The resulting sample was tested with the results shown in Fig. 10.

Fig. 10 is a leakage current graph for an approximately 2500 Å sample of $PbBi_2Ta_2O_9$. This material is of particular interest because the presence of lead makes it extremely resistant to radiation damage. The dielectric constant is 114 at 1 megahertz, which is smaller than that of $BaBi_2Ta_2O_9$, but still 30 to 40 times the dielectric constant of conventional semiconductor dielectrics. The leakage current is higher, but still excellent within the range of voltages common in integrated circuits. The elements from which the material is compounded are also relatively compatible with conventional integrated circuit materials.

As an eighth example, a capacitor device as shown in Fig. 2 having a layered superlattice material layer 30 made of barium bismuth niobate ($BaBi_2Nb_2O_9$) was fabricated in a similar process as described in the third example above. The resulting sample was tested with the results shown in Fig. 11.

The measured dielectric constant for $BaBi_2Nb_2O_9$ was 103.46. This is lower than the dielectric constants for $BaBi_2Ta_2O_9$ and $PbBi_2Ta_2O_9$, but still very high. Fig. 11 is a graph of the leakage current for $BaBi_2Nb_2O_9$. This leakage current result in again not as excellent as for $BaBi_2Ta_2O_9$ and $PbBi_2Ta_2O_9$, but still is good. Thus this material should be preferable to conventional integrated circuit dielectric materials. Again, this material should be relatively resistant to radiation damage as compared to conventional integrated circuit materials.

While as a by-product of the ferroelectric research described herein it has been found that the layered superlattice materials have many advantageous properties outside the ferroelectric area, which advantages and properties are also included in the invention, the primary thrust of research and the expected benefit of the new materials is in ferroelectrics. In the following paragraphs, the ferroelectric properties and advantages of the layered superlattice material will be summarized, using strontium bismuth tantalate ($SrBi_2Ta_2O_9$) as an exemplary material.

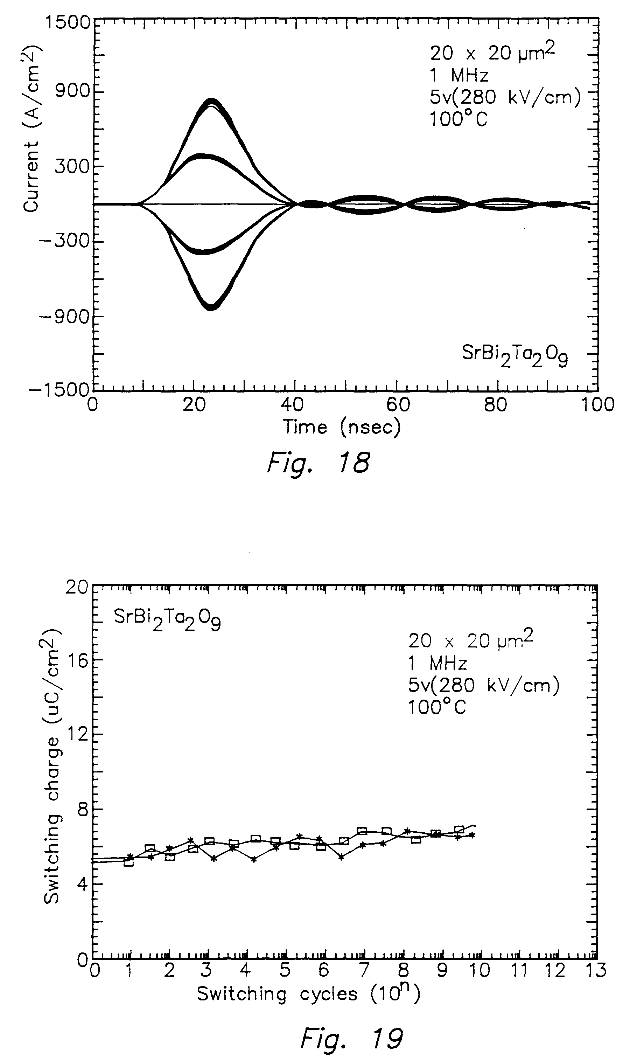

Turning to Fig. 16, a hysteresis curve for a sample of $SrBi_2Ta_2O_9$ after $10^{12}$ cycles superimposed on an initial hysteresis curve for the same sample is shown. $10^{12}$ cycles is roughly equivalent to device switching 1000 times a second for 25 years. This is far more switching than can be expected for a non-volatile memory cell. The two curves change so little that for about half the loop the curve for 1012 cycles retraces the initial curve. This is not an isolated, especially good sample. Fig. 17 shows 2Pr versus number of hysteresis cycles for three samples of $SrBi_2Ta_2O_9$, with the curve for one sample going out to $10^{12}$ cycles and the curve for the others going out to over $10^{11}$ cycles. The curves for all three samples are nearly superimposed. It is expected that as experience grows with the fabrication processes, the difference from one sample to the next will become even less. For the best of the prior art materials, PZT, 2Pr decreased more than 50% over only $10^9$ cycles, and varied widely from sample to sample.

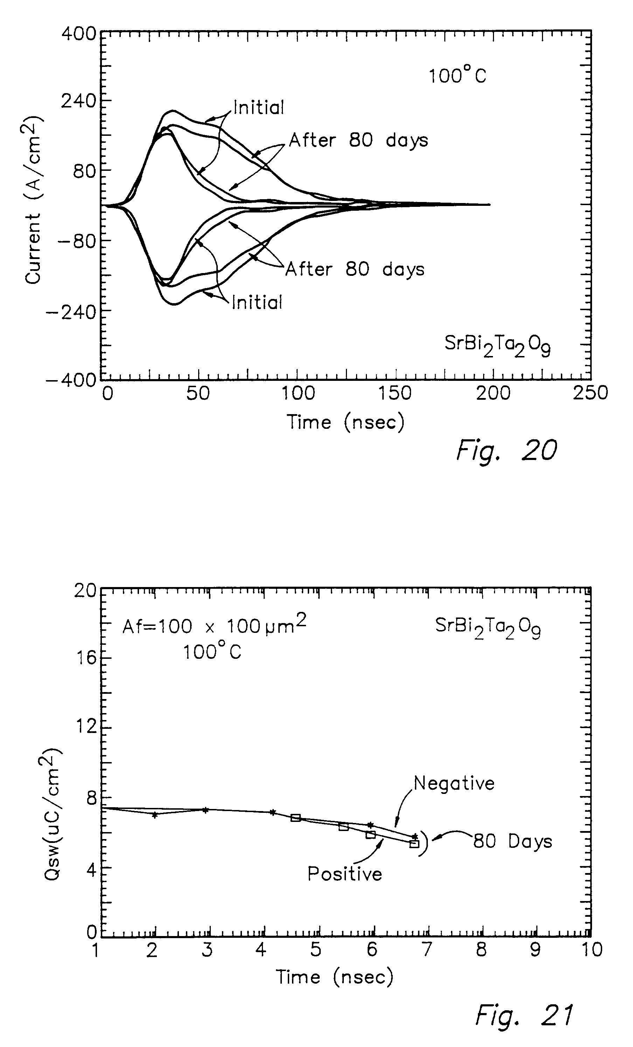

Because of the "shock absorber" feature of the layered superlattice materials, they also can perform under stressful conditions. Fig. 18 shows superimposed PUND switching measurements performed on a sample of $SrBi_2Ta_2O_9$ at 17 data points over approximately $10^{10}$ switching cycles at a temperature of 100°C, and Fig. 19 shows the switching charge versus number of switching cycles for the PUND measurements of Fig. 18. The PUND measurements are so consistent that the line of the curve merely grows thicker, without disturbing any of the features of the curve. Fig. 20 shows PUND measurements for a sample of $SrBi_2Ta_2O_9$ taken after the sample had retained a polarization charge for 80 days at 100°C superimposed on the initial PUND measurements for the same sample. While there was significant change, the percentage change was relatively constant over the entire curves so that the shape of the curves stayed the same. The switching current still remains well within the range sufficient to operate a switching device. Fig. 21 shows the decay of a switching charge for the positive and negative polarization state for samples of $SrBi_2Ta_2O_9$ illustrating data retention over an eighty day period at 100°C. The graph was made by negatively polarizing, i.e. programming, seven samples of $SrBi_2Ta_2O_9$ and positively polarizing seven other samples, then placing them in a storage container and holding them at 100°C. About every ten days to twelve days one of the negatively charged samples and one of the positively charged samples were removed from storage and the switching charge measured. Thus the curve not only shows the retention of programming for eighty days at 100°C, but also shows consistency between samples. There clearly was sufficient charge remaining after 80 days to operate a memory function.

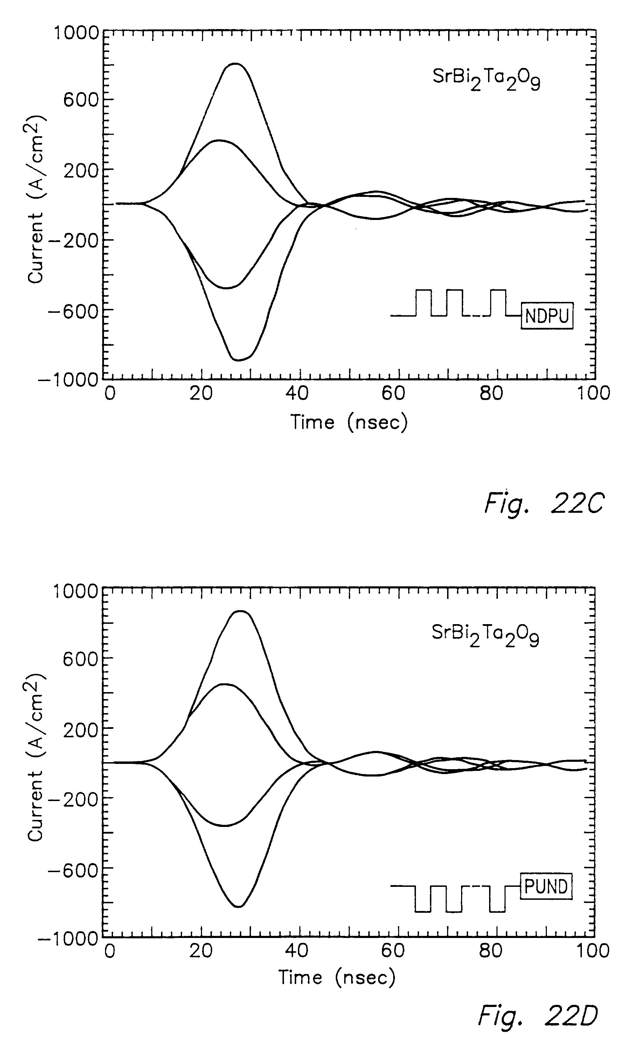

Figs. 22A through 22D illustrate the fact that there is little or no imprinting with $SrBi_2Ta_2O_9$ material: Fig. 22A shows the results of an initial PUND measurement for a virgin sample of $SrBi_2Ta_2O_9$; Fig. 22B shows the results of a PUND measurement taken on a sample of $SrBi_2Ta_2O_9$ after pulsing the sample with bipolar pulses at 1 MHZ for one hour at 84°C; Fig. 22C shows the results of a PUND measurement taken on a sample of $SrBi_2Ta_2O_9$ after pulsing the sample with positive pulses at 1 MHZ for one hour at 84°C; and Fig. 22D shows the results of a PUND measurement taken on a sample of $SrBi_2Ta_2O_9$ after pulsing the sample with negative pulses at 1 MHZ for one hour at 84°C. In identical tests run on prior art PZT, the overall level of the curves drop by more than 30% and the shape of the curves changes so much that the reliability of the material in a memory would be compromised. In the series of tests on $SrBi_2Ta_2O_9$ shown in Figs. 22A through 22D, there is not significant change in either the level of the curves or the shape of the curves in any test. In fact that changes are so small that it would be difficult to guess which was the initial curve if one were not told. Thus the layered superlattice material shows little or no evidence of imprinting.

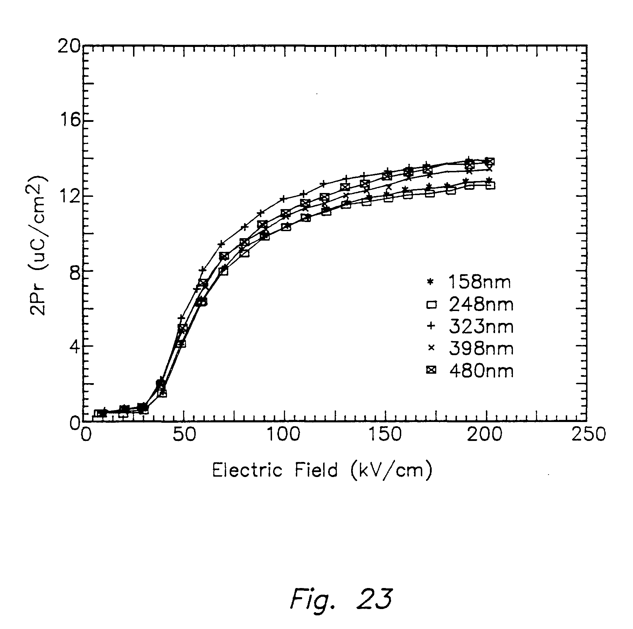

Fig. 23 shows 2Pr versus the electric field for five different samples of $SrBi_2Ta_2O_9$ having a variety of thicknesses. Changing the thickness by a factor of three changes the polarizability by less than 20%. In a similar test with prior art PZT the polarizability changes by three to four times this amount. When fabricating thin film devices, it is difficult to control the thickness of the layers within about 10%. Thus is should be much easier to design and fabricate a layered thin film device, such as an integrated circuit, with predictable specifications out of the layered superlattice materials than it is for prior art materials.

There has been described a new class of ferroelectric and high dielectric constant materials and greatly improved dielectric capacitors, switching capacitors, and integrated circuit memories which have many advantages. It should be understood that the particular embodiments shown in the drawings and described within this specification are for purposes of example and should not be construed to limit the invention which is defined in the following claims.

**Claims**

**1.** An integrated circuit memory (36) comprising:

a memory cell (70,70') including a thin film of material (60,60') either as a ferroelectric switching material or as a capacitor dielectric;
information write means (80,80') for placing said memory cell in a selected state corresponding to information input to said memory; and
information read means (82) for sensing said selected state of said memory cell (70,70') and providing a signal corresponding to said selected state;

characterised in that said thin film is a material (60,60'), referred to herein as a layered superlattice material, which spontaneously forms into a layered structure (89,92) and has the formula:

$$A1_{w1}^{+a1} A2_{w2}^{+a2} ...Aj_{wj}^{+aj} S1_{x1}^{+s1} S2_{x2}^{+s2} ...Sk_{xk}^{+sk} B1_{y1}^{+b1} B2_{y2}^{+b2} ...Bl_{yl}^{+bl} Q_z^{-2},$$

where A1, A2...Aj represent A-site elements (84) in a perovskite-like structure, S1, S2...Sk represent superlattice generator elements (87), B1, B2...B1 represent B-site elements (86) in said perovskite-like structure, Q represents an anion (88), the superscripts indicate the valences of the respective elements (84), (86), (87), (88), the subscripts indicate the average number of atoms of the element in the unit cell (89), the value of z is found from the equation:

$$(a1w1 + a2w2... + ajwj) + (s1x1 + s2x2...+ skxk) + (b1y1 +$$

$$b2y2... + blyl) = 2z,$$

w1, x1 and y1 are non-zero, and one of A1, B1 and S1 is bismuth.

2.  An integrated circuit memory according to claim 1, wherein said A-site element comprises one or more elements from the group consisting of strontium, calcium, barium, bismuth, cadmium and lead.

3.  An integrated circuit memory according to claim 1 or claim 2, wherein said B-site element comprises one or more elements from the group consisting of titanium, tantalum, hafnium, tungsten, niobium, and zirconium.

4.  An integrated circuit memory according to any one of claims 1 to 3, wherein said superlattice generator element comprises one or more elements from the group consisting of bismuth, scandium, yttrium, lanthanum, antimony, chromium, and thallium.

5.  An integrated circuit memory according to any one of the preceding claims, wherein said layered superlattice material (60,60') forms perovskite-like layers (94) of the oxygen octahedral type, and non-perovskite-like layers (96) comprising bismuth oxide.

6.  An integrated circuit memory according to claim 5, wherein said layered superlattice material (60,60') is selected from the group consisting of strontium bismuth tantalate, strontium bismuth niobate, strontium bismuth tantalum niobate, lead bismuth niobate, barium bismuth tantalate, lead bismuth tantalate, barium bismuth niobate, strontium bismuth titanate, and combinations thereof.

7.  An integrated circuit memory according to any one of the preceding claims, wherein said memory is a ferroelectric memory and said layered superlattice material (60) is a ferroelectric material capable of switching between a first state and a second state at least $10^9$ times with less than 30% fatigue.

8.  An integrated circuit memory according to any one of claims 1 to 6, wherein said memory is a dielectric memory and said layered superlattice material (60') has a dielectric constant greater than 50.

**Patentansprüche**

1.  Ein Integrierte-Schaltung-Speicher (36) mit folgenden Merkmalen:

    einer Speicherzelle (70, 70'), die entweder als ein ferroelektrisches schaltendes Material oder als ein Kondensatordielektrikum einen dünnen Film aus Material (60, 60') umfaßt;

    einer Informationen-Schreibe-Einrichtung (80, 80') zum Versetzen der Speicherzelle in einen ausgewählten Zustand, welcher den Informationen entspricht, die in den Speicher eingegeben werden; und

    einer Informationen-Lese-Einrichtung (82) zum Erfassen des ausgewählten Zustandes der Speicherzelle (70, 70') und zum Liefern eines Signals, das dem ausgewählten Zustand entspricht,

    dadurch gekennzeichnet, daß der dünne Film aus einem Material (60, 60') ist, das hier als schichtiges Übergittermaterial bezeichnet wird, und das spontan eine schichtige Struktur (89, 92) bildet und die Formel

$$A1^{+a1}_{w1} A2^{+a2}_{w2} Aj^{+aj}_{wj} S1^{+s1}_{x1} S2^{+s2}_{x2} ... Sk^{+sk}_{xk} B1^{+b1}_{y1} B2^{+b2}_{y2} ... Bl^{+bl}_{yl} Q^{-2}_{z}$$

    aufweist, wobei A1, A2 ... Aj A-Platz-Elemente (84) in einer perovskitähnlichen Struktur darstellen, wobei S1, S2 ... Sk Übergitter-Erzeuger-Elemente (87) darstellen, wobei B1, B2 ... Bl B-Platz-Elemente (86) in der perovskitähnlichen Struktur darstellen, wobei Q ein Anion (88) darstellt, wobei die oberen Indizes die Valenzen der jeweiligen Elemente (84), (86), (87), (88) anzeigen, wobei die unteren Indizes die mittlere Anzahl von Atomen des Elements in der Einheitszelle (89) anzeigen, wobei der Wert von z sich aus der Gleichung

$$(a1w1 + a2w2... + ajwj) + (s1x1 + s2x2... + skxk) +$$

$$(b1y1 + b2y2... + blyl) = 2z$$

ergibt, wobei w1, x1 und y1 nicht Null sind, und wobei eines von A1, B1 und SI Bismut ist.

2. Ein Integrierte-Schaltung-Speicher gemäß Anspruch 1, bei dem das A-Platz-Element eines oder mehrere Elemente aus der Gruppe aufweist, die aus Strontium, Kalzium, Barium, Bismut, Cadmium und Blei besteht.

3. Ein Integrierte-Schaltung-Speicher gemäß Anspruch 1 oder Anspruch 2, bei dem das B-Platz-Element eines oder mehrere Elemente aus der Gruppe aufweist, die aus Titan, Tantal, Hafnium, Wolfram, Niob und Zirkonium besteht.

4. Ein Integrierte-Schaltung-Speicher gemäß einem der Ansprüche 1 bis 3, bei dem das Übergitter-Erzeuger-Element eines oder mehrere Elemente aus der Gruppe aufweist, die aus Bismut, Skandium, Yttrium, Lanthan, Antimon, Chrom und Thallium besteht.

5. Ein Integrierte-Schaltung-Speicher gemäß einem der vorangehenden Ansprüche, bei dem das schichtige Übergittermaterial (60, 60') perovskitähnliche Schichten (94) des Sauerstoff-Oktaeder-Typs und nichtperovskitähnliche Schichten (96) bildet, die Bismutoxid aufweisen.

6. Ein Integrierte-Schaltung-Speicher gemäß Anspruch 5, bei dem das schichtige Übergittermaterial (60, 60') aus der Gruppe ausgewählt ist, die aus Strontium-Bismut-Tantalat, Strontium-Bismut-Niobat, Strontium-Bismut-Tantal-Niobat, Blei-Bismut-Niobat, Barium-Bismut-Tantalat, Blei-Bismut-Tantalat, Barium-Bismut-Niobat, Strontium-Bismut-Titanat und Kombinationen derselben besteht.

7. Ein Integrierte-Schaltung-Speicher gemäß einem der vorangehenden Ansprüche, bei dem der Speicher ein ferroelektrischer Speicher ist und bei dem das schichtige Übergittermaterial (60) ein ferroelektrisches Material ist, das mindestens $10^9$ mal mit weniger als 30% Alterung zwischen einem ersten Zustand und einem zweiten Zustand schalten kann.

8. Ein Integrierte-Schaltung-Speicher gemäß einem der Ansprüche 1 bis 6, bei dem der Speicher ein dielektrischer Speicher ist, und bei dem das schichtige Übergittermaterial (60') eine dielektrische Konstante größer als 50 aufweist.

**Revendications**

1. Mémoire (36) à circuits intégrés comprenant :

une cellule (70, 70') de mémoire comprenant une pellicule mince de matériau (60, 60') en tant que matériau de commutation ferroélectrique ou en tant que matériau diélectrique pour capacité ;
un moyen d'écriture (80, 80') de l'information pour placer ladite cellule de mémoire dans un état sélectionné correspondant à l'entrée d'information à ladite mémoire ; et
un moyen de lecture (82) de l'information pour détecter ledit état sélectionné de ladite cellule (70, 70') de mémoire et pour fournir un signal correspondant audit état sélectionné ;

caractérisée en ce que ladite pellicule mince est un matériau (60, 60') appelé ici matériau lamellaire à sur-structure, qui se forme spontanément en une structure lamellaire (89, 92) et possède la formule :

$$A1_{w1}^{+a1}\ A2_{w2}^{+a2}\ \cdots\ Aj_{wj}^{+aj}\ S1_{x1}^{+s1}\ S2_{x2}^{+s2}\ \cdots Sk_{xk}^{+sk}\ B1_{y1}^{+b1}\ B2_{y2}^{+b2}\ \cdots\ Bl+_{yl}^{bl}\ Q_z^{-2},$$

dans laquelle A1, A2...Aj représentent des éléments (84) sur le site A dans une structure de type perovskite, S1, S2...Sk représentent des éléments (87) générateurs de sur-structure, B1, B2...Bl représentent des éléments (86) sur le site B dans ladite structure de type perovskite, Q représente un anion (88), les exposants indiquant les valences des éléments respectifs (84), (86), (87), (88), les indices indiquant le nombre moyen d'atomes de l'élément dans la cellule unitaire (89), la valeur de z étant trouvée à partir de l'équation :

$$(a1w1+a2w2...+ajwj) + (s1x1+s2x2...+skxk) + (b1y1+b2y2...+blyl) = 2z,$$

w1, x1 et y1 étant différents de zéro, et un de A1, B1 et S1 étant le bismuth.

2.  Mémoire à circuits intégrés selon la revendication 1, caractérisée en ce que l'élément sur le site A comprend un ou plusieurs éléments du groupe constitué par le strontium, le calcium, le baryum, le bismuth, le cadmium et le plomb.

3.  Mémoire à circuits intégrés selon la revendication 1 ou la revendication 2, caractérisée en ce que ledit élément sur le site B comprend un ou plusieurs éléments du groupe constitué par le titane, le tantale, l'hafnium, le tungstène, le niobium, et le zirconium.

4.  Mémoire à circuits intégrés selon l'une quelconque des revendications 1 à 3, caractérisée en ce que l'élément générateur de sur-structure comprend un ou plusieurs éléments du groupe constitué par le bismuth, le scandium, l'yttrium, le lanthane, l'antimoine, le chrome, et le thallium.

5.  Mémoire à circuits intégrés selon l'une quelconque des revendications précédentes, caractérisée en ce que ledit matériau lamellaire à sur-structure (60, 60') forme des couches de type perovskite (94) du type octaèdre d'oxygène, et des couches du type non perovskite (96) comprenant l'oxyde de bismuth.

6.  Mémoire à circuits intégrés selon la revendication 5, caractérisée en ce que ledit matériau lamellaire à sur-structure (60, 60') est choisi dans le groupe constitué par le tantalate de strontium bismuth, le niobate de strontium bismuth, le niobate de strontium bismuth tantale, le niobate de plomb bismuth, le tantalate de baryum bismuth, le tantalate de plomb bismuth, le niobate de baryum bismuth, le titanate de strontium bismuth, et des combinaisons de ceux-ci.

7.  Mémoire à circuits intégrés selon l'une quelconque des revendications précédentes, caractérisée en ce que ladite mémoire est une mémoire ferroélectrique et en ce que ledit matériau lamellaire à sur-structure (60) est un matériau ferroélectrique capable de commuter entre un premier état et un second état au moins $10^9$ fois avec moins de 30% de fatigue.

8.  Mémoire à circuits intégrés selon l'une quelconque des revendications 1 à 6, caractérisée en ce que ladite mémoire est une mémoire diélectrique et en ce que ledit matériau lamellaire à sur-structure (60') a une constante diélectrique supérieure à 50.

Fig. 1A

1B        1B
17B
16
8
17A

1

Fig. 1B

16
14
12
10
8
6
4
2

1

Fig. 2

20

32
30
28
26
24
22

Fig. 3A

*Fig. 3B*

*Fig. 3C*

*Fig. 3D*

Fig. 4

Fig. 5A

FIG. 5B

Fig. 6A

*Fig. 6B*

*Fig. 7*

*Fig. 8A*

*Fig. 8B*

*Fig. 8C*

*Fig. 8D*

Fig. 8E

Fig. 9

Fig. 10

Fig. 11

Fig. 12A

A B Q

Fig. 12B

A B Q

*Fig. 13*

*Fig. 14*

A ◖
Bi ◯
B ●
O ◯

$ABi_2B_2^{+5}O_9$

_Fig. 15_

$ABi_2B_4^{+4}O_{15}$

Fig. 16

Fig. 17

20 x 20 $\mu m^2$
1 MHz
5v(280 kV/cm)
100°C

$SrBi_2Ta_2O_9$

*Fig. 18*

$SrBi_2Ta_2O_9$

20 x 20 $\mu m^2$
1 MHz
5v(280 kV/cm)
100°C

*Fig. 19*

Fig. 20

Fig. 21

Fig. 22A

Fig. 22B

Fig. 22C

Fig. 22D

*Fig. 23*